# EUROPEAN PATENT APPLICATION

(11) **EP 4 629 800 A2**
(43) Date of publication of application: **08.10.2025**
(21) Application number: 25157713.6
(22) Date of filing: 13.02.2025
(51) Int. Cl.: H10K 59/131

(54) **DISPLAY APPARATUS AND ELECTRONIC DEVICE INCLUDING THE SAME**

(30) Priority: 03.04.2024 KR 20240045517
(71) Applicant: Samsung Display Co., Ltd., Yongin-si, Gyeonggi-do 17113 (KR)
(72) Inventor: KIM, Hansol, 17113 Yongin-si, Gyeonggi-do (KR); KIM, Wansu, 17113 Yongin-si, Gyeonggi-do (KR); LIM, Chaeyeol, 17113 Yongin-si, Gyeonggi-do, (KR); CHO, Youngjin, 17113 Yongin-si, Gyeonggi-do (KR); JO, Eunbyul, 17113 Yongin-si, Gyeonggi-do (KR)
(74) Representative: Gulde & Partner

(57) **Abstract**

A display apparatus includes a substrate including a display area and a peripheral area, unit pixel areas in the display area, and including a first pixel circuit, a second pixel circuit, and a third pixel circuit, a power voltage supply line in the peripheral area, a first driving voltage line electrically connected to the power voltage supply line, and having a mesh structure in the display area, and a second driving voltage line electrically connected to the power voltage supply line, at a different layer from the first driving voltage line, extending in a first direction in the display area, and connected to the first driving voltage line through at least one inner contact hole in the unit pixel areas.

## Description

### CROSS-REFERENCE TO RELATED APPLICATION

The present application claims priority to, and the benefit of, Korean Patent Application No. 10-2024-0045517, filed on April 03, 2024, in the Korean Intellectual Property Office, the disclosure of which is incorporated by reference herein in its entirety.

### BACKGROUND

### 1. Field

One or more embodiments relate to a display apparatus.

### 2. Description of the Related Art

Recently, the usage of display apparatuses has diversified. Moreover, display apparatuses have become thinner and lighter, and thus, the usage range thereof has widened.

As display apparatuses have been used for various purposes, there have been various methods of designing the shapes of display apparatuses, and designs for expanding a display area while maintaining high display quality have increased.

### SUMMARY

One or more embodiments include a display apparatus having improved display quality. However, this aspect is only an example, and the scope of the disclosure is not limited thereto.

Additional aspects will be set forth in part in the description which follows and, in part, will be apparent from the description, or may be learned by practice of the presented embodiments of the disclosure.

According to one or more embodiments, a display apparatus includes a substrate including a display area and a peripheral area, unit pixel areas in the display area, and including a first pixel circuit, a second pixel circuit, and a third pixel circuit, a power voltage supply line in the peripheral area, a first driving voltage line electrically connected to the power voltage supply line, and having a mesh structure in the display area, and a second driving voltage line electrically connected to the power voltage supply line, at a different layer from the first driving voltage line, extending in a first direction in the display area, and connected to the first driving voltage line through at least one inner contact hole in the unit pixel areas.

A step difference having a stair shape may be at a side surface defining the at least one inner contact hole.

The display apparatus may further include a first insulating layer and a second insulating layer that are stacked between the first driving voltage line and the second driving voltage line, wherein the at least one inner contact hole includes a first through hole of the first insulating layer, and a second through hole of the second insulating layer, the first through hole and the second through hole overlapping each other, and a width of the first through hole being different from a width of the second through hole.

The first driving voltage line may include a portion extending in the first direction and overlapping the second driving voltage line, and a portion extending in a second direction crossing the first direction.

The display apparatus may further include a third driving voltage line electrically connected to the power voltage supply line, at a different layer from the first driving voltage line and the second driving voltage line, extending in a second direction crossing the first direction in the display area, and connected to the second driving voltage line through at least one inner via hole in each of the unit pixel areas.

The display apparatus may further include a third insulating layer between the second driving voltage line and the third driving voltage line, and defining the at least one inner via hole, the at least one inner via hole not overlapping the at least one inner contact hole.

The first driving voltage line may include a portion extending in the first direction, and a portion extending in the second direction, and overlapping the third driving voltage line.

The power voltage supply line may be in the peripheral area, and may include a first power voltage supply line surrounding the display area in plan view at a same layer as the first driving voltage line, a second power voltage supply line at a same layer as the second driving voltage line, and a third power voltage supply line at a different layer from the first power voltage supply line and the second power voltage supply line.

The second power voltage supply line may extend in the first direction in the peripheral area.

The first power voltage supply line and the second power voltage supply line may be connected through outer contact holes in the peripheral area.

A step difference having a stair shape may be at a side surface defining one of the outer contact holes.

The third power voltage supply line may be connected to the second power voltage supply line through outer via holes, at least one of the outer via holes at least partially overlapping the outer contact holes.

The first power voltage supply line may be integral with the first driving voltage line.

The first pixel circuit may include a first thin-film transistor including a silicon semiconductor layer, and a second thin-film transistor including an oxide semiconductor layer, wherein the first driving voltage line overlaps at least one of the first thin-film transistor or the second thin-film transistor.

According to one or more embodiments, a display apparatus includes a substrate including a display area and a peripheral area, a pixel circuit in the display area, and including a first thin-film transistor including a first semiconductor layer and a second thin-film transistor including a second semiconductor layer at a different layer from the first semiconductor layer, a display element connected to the pixel circuit, a first driving voltage line between the substrate and the first semiconductor layer, a first insulating layer below the second semiconductor layer, and covering the first semiconductor layer, a second insulating layer above the first insulating layer, and covering the second semiconductor layer, a second driving voltage line above the second insulating layer, and connected to the first driving voltage line through an inner contact hole in the display area, a third insulating layer above the second insulating layer, and covering the second driving voltage line, and a third driving voltage line above the third insulating layer.

The inner contact hole may include a first through hole of the first insulating layer and a second through hole of the second insulating layer, the first through hole and the second through hole overlapping each other.

A width of the first through hole may be different from a width of the second through hole.

The third driving voltage line may be connected to the second driving voltage line through an inner via hole defined in the third insulating layer in the display area.

The first driving voltage line may overlap at least one of the first thin-film transistor or the second thin-film transistor.

The display element may include organic light-emitting diodes having a tandem structure, wherein a pixel-defining layer defining an emission area of the organic light-emitting diodes includes a separator between the organic light-emitting diodes, and having a concave structure.

According to one or more embodiments, an electronic device includes a display apparatus, wherein the display apparatus includes a substrate including a display area and a peripheral area, a plurality of unit pixel areas arranged in the display area and each including a first pixel circuit, a second pixel circuit, and a third pixel circuit, a power voltage supply line arranged in the peripheral area, a first driving voltage line electrically connected to the power voltage supply line and arranged in the display area to have a mesh structure, and a second driving voltage line electrically connected to the power voltage supply line, disposed on a different layer from the first driving voltage line, and extending in a first direction in the display area, wherein the first driving voltage line is connected to the second driving voltage line through at least one inner contact hole in each of the plurality of unit pixel areas.

### BRIEF DESCRIPTION OF THE DRAWINGS

The above and other aspects of embodiments of the disclosure will be more apparent from the following description taken in conjunction with the accompanying drawings, in which:
FIG. 1 is a schematic plan view of a display apparatus according to one or more embodiments;
FIG. 2 is a schematic plan view of a portion of a display area according to one or more embodiments;
FIG. 3 is a cross-sectional view of a region taken along the line I-I' of FIG. 2;
FIG. 4 is a circuit diagram of a pixel circuit according to one or more embodiments;
FIG. 5 is a schematic layout view of a driving voltage line arranged in a unit pixel area;
FIG. 6 is a cross-sectional view of some elements corresponding to a region taken along the line II-II' of FIG. 5;
FIG. 7 is a cross-sectional view of some elements corresponding to a region taken along the line III-III' of FIG. 5;
FIG. 8 is a schematic layout view of a power voltage supply line arranged in a peripheral area;
FIG. 9 is a cross-sectional view of some elements corresponding to a region taken along the line IV-IV' of FIG. 8;
FIG. 10 is a schematic layout view of positions of transistors and a storage capacitor of a pixel circuit according to one or more embodiments;
FIGS. 11 to 20 are schematic layout views of elements of the pixel circuit illustrated in FIG. 10, which are located on each layer;
FIG. 21 is a planar layout view of only some of elements of a display apparatus according to one or more embodiments; and
FIG. 22 is a schematic cross-sectional view of a display apparatus according to one or more embodiments.

### DETAILED DESCRIPTION

Aspects of some embodiments of the present disclosure and methods of accomplishing the same may be understood more readily by reference to the detailed description of embodiments and the accompanying drawings. The described embodiments are provided as examples so that this disclosure will be thorough and complete, and will fully convey the aspects of the present disclosure to those skilled in the art. Accordingly, processes, elements, and techniques that are redundant, that are unrelated or irrelevant to the description of the embodiments, or that are not necessary to those having ordinary skill in the art for a complete understanding of the aspects of the present disclosure may be omitted. Unless otherwise noted, like reference numerals, characters, or combinations thereof denote like elements throughout the attached drawings and the written description, and thus, repeated descriptions thereof may be omitted.

The described embodiments may have various modifications and may be embodied in different forms, and should not be construed as being limited to only the illustrated embodiments herein. The use of "can," "may," or "may not" in describing an embodiment corresponds to one or more embodiments of the present disclosure.

A person of ordinary skill in the art would appreciate, in view of the present disclosure in its entirety, that the present disclosure covers all modifications, equivalents, and replacements within the idea and technical scope of the present disclosure, that each of the features of embodiments of the present disclosure may be combined with each other, in part or in whole, and technically various interlocking and operating are possible, and that each embodiment may be implemented independently of each other, or may be implemented together in an association, unless otherwise stated or implied.

In the drawings, the relative sizes of elements, layers, and regions may be exaggerated for clarity and/or descriptive purposes. In other words, because the sizes and thicknesses of elements in the drawings are arbitrarily illustrated for convenience of description, the disclosure is not limited thereto. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result of, for example, manufacturing techniques and/or tolerances, are to be expected. Further, specific structural or functional descriptions disclosed herein are merely illustrative for the purpose of describing embodiments according to the concept of the present disclosure. Thus, embodiments disclosed herein should not be construed as limited to the illustrated shapes of elements, layers, or regions, but are to include deviations in shapes that result from, for instance, manufacturing.

For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place.

Spatially relative terms, such as "beneath," "below," "lower," "lower side," "under," "above," "upper," "over," "higher," "upper side," "side" (e.g., as in "sidewall"), and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below," "beneath," "or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include stack, face or facing, extending over, covering, or partly covering or any other suitable term as would be appreciated and understood by those of ordinary skill in the art. The expression "not overlap" may include meaning, such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

It will be understood that when an element, layer, region, or component is referred to as being "formed on," "on," "connected to," or "(operatively or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or one or more intervening layers, regions, or components may be present. The one or more intervening components may include a switch, a resistor, a capacitor, and/or the like. In describing embodiments, an expression of connection indicates electrical connection unless explicitly described to be direct connection, and "directly connected/directly coupled," or "directly on," refers to one component directly connecting or coupling another component, or being on another component, without an intermediate component.

In addition, in the present specification, when a portion of a layer, a film, an area, a plate, or the like is formed on another portion, a forming direction is not limited to an upper direction but includes forming the portion on a side surface or in a lower direction. On the contrary, when a portion of a layer, a film, an area, a plate, or the like is formed "under" another portion, this includes not only a case where the portion is "directly beneath" another portion but also a case where there is further another portion between the portion and another portion. Meanwhile, other expressions describing relationships between components, such as "between," "immediately between" or "adjacent to" and "directly adjacent to," may be construed similarly. It will be understood that when an element or layer is referred to as being "between" two elements or layers, it can be the only element or layer between the two elements or layers, or one or more intervening elements or layers may also be present.

For the purposes of this disclosure, expressions such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XYY, YZ, and ZZ, or any variation thereof. Similarly, the expressions "at least one of A and B" and "at least one of A or B" may include A, B, or A and B. As used herein, "or" generally means "and/or," and the term "and/or" includes any and all combinations of one or more of the associated listed items. For example, the expression "A and/or B" may include A, B, or A and B. Similarly, expressions such as "at least one of," "a plurality of," "one of," and other prepositional phrases, when preceding a list of elements, modify the entire list of elements and do not modify the individual elements of the list. When "C to D" is stated, it means C or more and D or less, unless otherwise specified.

It will be understood that, although the terms "first," "second," "third," etc., may be used herein to describe various elements, components, regions, layers and/or sections, these elements, components, regions, layers and/or sections should not be limited by these terms. These terms do not correspond to a particular order, position, or superiority, and are used only used to distinguish one element, member, component, region, area, layer, section, or portion from another element, member, component, region, area, layer, section, or portion. Thus, a first element, component, region, layer or section described below could be termed a second element, component, region, layer or section, without departing from the spirit and scope of the present disclosure. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

In the examples, the x-axis, the y-axis, and/or the z-axis are not limited to three axes of a rectangular coordinate system, and may be interpreted in a broader sense. For example, the x-axis, the y-axis, and the z-axis may be perpendicular to one another, or may represent different directions that are not perpendicular to one another. The same applies for first, second, and/or third directions.

The terminology used herein is for the purpose of describing embodiments only and is not intended to be limiting of the present disclosure. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

As used herein, the terms "substantially," "about," "approximately," and similar terms are used as terms of approximation and not as terms of degree, and are intended to account for the inherent deviations in measured or calculated values that would be recognized by those of ordinary skill in the art. For example, "substantially" may include a range of +/- 5 % of a corresponding value. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure."

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

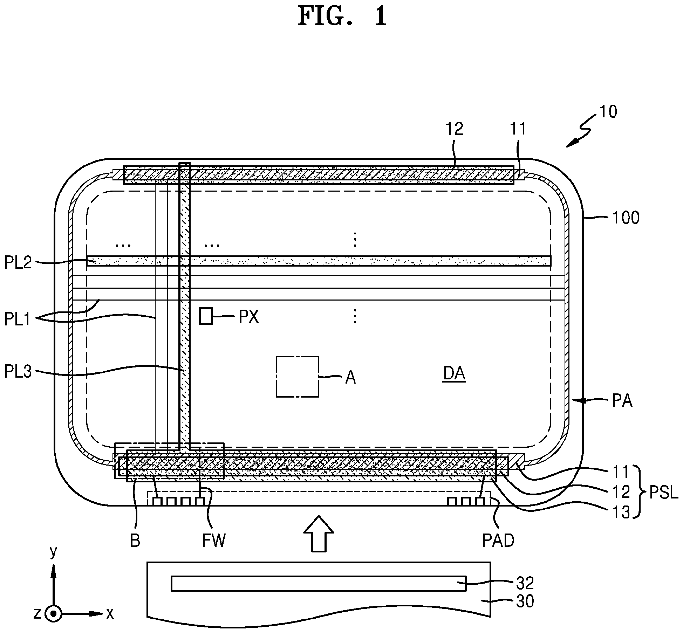

FIG. 1 is a schematic plan view of a portion of a display apparatus 10 according to one or more embodiments.

The display apparatus 10 may include a light-emitting display apparatus including a light-emitting element that is a display element. For example, the display apparatus 10 may include an organic light-emitting display apparatus using an organic light-emitting diode including an organic emission layer, a micro light-emitting diode display apparatus using a micro light-emitting diode, a quantum dot light-emitting display apparatus using a quantum dot light-emitting diode, or an inorganic light-emitting display apparatus using an inorganic light-emitting diode including an inorganic semiconductor.

The display apparatus 10 may include a display area DA realizing an image, and a peripheral area PA outside the display area DA. The peripheral area PA may be a type of non-display area in which display elements are not arranged. The display area DA may be entirely surrounded by the peripheral area PA. Various elements included in the display apparatus 10 may be located on a substrate 100. Thus, it may be understood that the substrate 100 may include the display area DA and the peripheral area PA.

A plurality of pixels PX may be arranged in the display area DA. The pixel PX may include the display element. The display element may be connected to a pixel circuit configured to drive the pixel PX. According to one or more embodiments, the display element may include an organic light-emitting diode. Each pixel PX may emit, for example, red, green, blue, or white light through the organic light-emitting diode. The plurality of pixels PX may include a first pixel for emitting light of a first color, a second pixel for emitting light of a second color, and a third pixel for emitting light of a third color. For example, the first pixel may be a red pixel, the second pixel may be a green pixel, and the third pixel may be a blue pixel. According to one or more embodiments, the plurality of pixels PX may further include a white pixel for emitting light of a white color.

In the peripheral area PA, various lines configured to transmit electrical signals to be applied to the display area DA, external circuits electrically connected to the pixel circuits configured to drive the pixels, and pads onto which a printed circuit board (PCB) or a driver integrated circuit (IC) chip is attached may be arranged. For example, in one or more embodiments, in the peripheral area PA, a scan-driving circuit, a terminal portion PAD, a power voltage supply line PSL, and a common voltage supply line may be arranged.

The terminal portion PAD may be arranged at a side of the substrate 100. The terminal portion PAD may not be covered by an insulating layer to be exposed, and may be connected to a display circuit board 30. A display driver 32 may be located on the display circuit board 30. The display driver 32 may be formed in the form of one or more IC chips, and may be mounted above the display circuit board 30.

The display driver 32 may be configured to generate a control signal and a data signal transmitted to the scan-driving circuit. The control signal or the data signal may be transmitted, through a fan-out line FW connected to the terminal portion PAD, to the pixel circuits configured to drive the pixels PX of the display area DA.

The display driver 32 may be configured to supply a driving voltage ELVDD to the power voltage supply line PSL. Through a first driving voltage line PL1, a second driving voltage line PL2, and a third driving voltage line PL3 connected to the power voltage supply line PSL, the driving voltage ELVDD may be applied to the pixel circuits configured to drive the pixels PX.

The power voltage supply line PSL may include a first power voltage supply line 11, a second power voltage supply line 12, and a third power voltage supply line 13 located on different layers from each other.

The first power voltage supply line 11 may be arranged in the peripheral area PA to at least partially surround the display area DA. The first power voltage supply line 11 may extend in an x direction at a lower side of the display area DA and at an upper side of the display area DA. If the first power voltage supply line 11 is arranged to entirely surround the display area DA, portions of the first power voltage supply line 11 arranged at the lower side and the upper side of the display area DA may have a greater width than portions of the first power voltage supply line 11 arranged at a left side and a right side of the display area DA.

The second power voltage supply line 12 may be directly connected to the terminal portion PAD through the fan-out line FW, and may extend in the x direction at the lower side of the display area DA. In a plan view, the second power voltage supply line 12 may extend in the x direction between the terminal portion PAD and the display area DA. Alternatively, the second power voltage supply line 12 may extend in the x direction at the lower side and the upper side of the display area DA. The second power voltage supply line 12 may be arranged to overlap the first power voltage supply line 11. The second power voltage supply line 12 may be connected to the first power voltage supply line 11 through at least one outer contact hole.

The third power voltage supply line 13 may extend in the x direction at the lower side of the display area DA. In the plan view, the third power voltage supply line 13 may extend in the x direction between the terminal portion PAD and the display area DA. The third power voltage supply line 13 may be arranged to overlap the first power voltage supply line 11 and the second power voltage supply line 12. The third power voltage supply line 13 may be connected to the second power voltage supply line 12 through at least one outer via hole.

The first power voltage supply line 11, the second power voltage supply line 12, and the third power voltage supply line 13 may be electrically connected to each other, and thus, all of the first to third power voltage supply lines 11, 12, and 13 may be configured to supply the driving voltage ELVDD.

The first power voltage supply line 11 may be connected to the first driving voltage line PL1, and may be configured to transmit the driving voltage ELVDD to the display area DA. The first driving voltage line PL1 may be integrally provided with the first power voltage supply line 11. The first driving voltage line PL1 may be arranged to have a mesh structure in the display area DA. That is, the first driving voltage line PL1 may include a portion extending in the x direction, and a portion extending in a y direction. The portion of the first driving voltage line PL1 extending in the x direction may be connected to the first power voltage supply line 11 arranged at the left and right sides of the display area DA. The portion of the first driving voltage line PL1 extending in the y direction may be connected to the first power voltage supply line 11 arranged at the upper and lower sides of the display area DA.

The second power voltage supply line 12 may be connected to the second driving voltage line PL2, and may be configured to transmit the driving voltage ELVDD to the display area DA. The second driving voltage line PL2 may be integrally provided with the second power voltage supply line 12. The second driving voltage line PL2 may extend in the x direction in the display area DA.

The third power voltage supply line 13 may be connected to the third driving voltage line PL3, and may be configured to transmit the driving voltage ELVDD to the display area DA. The third driving voltage line PL3 may be integrally provided with the third power voltage supply line 13. The third driving voltage line PL3 may extend in the y direction in the display area DA.

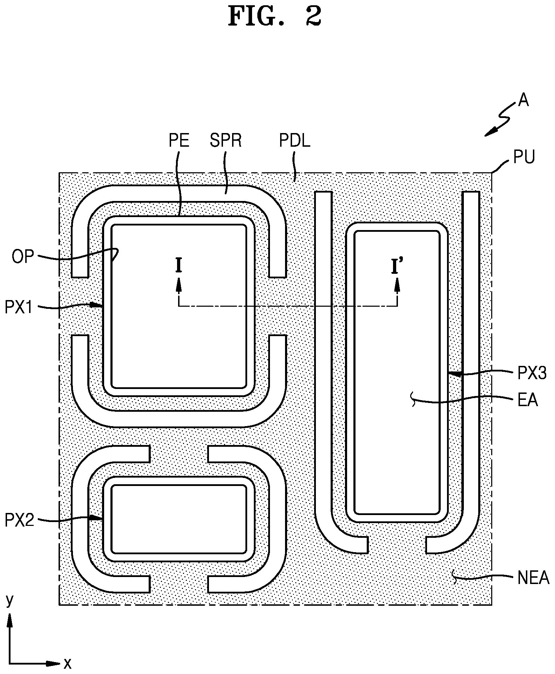

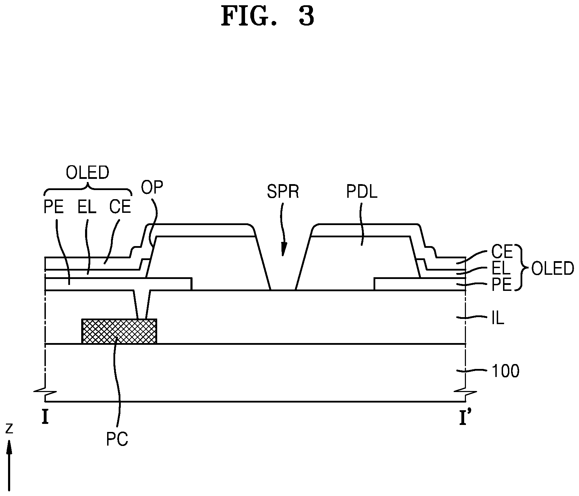

FIG. 2 is a schematic plan view of a portion of the display area DA according to one or more embodiments. FIG. 2 illustrates region A of the display area DA of FIG. 1, and illustrates one unit pixel area PU. FIG. 3 is a cross-sectional view of a region of the unit pixel area PU, taken along the line I-I' of FIG. 2.

Referring to FIGS. 2 and 3, a plurality of organic light-emitting diodes OLED, which are light-emitting devices, may be arranged on the substrate 100. The organic light-emitting diode OLED may include a pixel electrode PE, an opposite electrode CE, and an emission layer EL between the pixel electrode PE and the opposite electrode CE.

Hereinafter, a display apparatus according to one or more embodiments is described as an organic light-emitting display apparatus including the organic light-emitting diode OLED, for example. However, the display apparatus 10 is not limited thereto. According to one or more other embodiments, the display apparatus 10 according to the disclosure may include an inorganic light-emitting display apparatus, an inorganic electroluminescent (EL) display apparatus, or a quantum dot light-emitting display apparatus.

A plurality of pixel circuits PC may be located between the substrate 100 and the plurality of organic light-emitting diodes OLED, and the plurality of organic light-emitting diodes OLED may be connected to the plurality of pixel circuits PC, respectively. For example, the pixel electrode PE of the organic light-emitting diode OLED may be connected to the pixel circuit PC. The pixel circuit PC may include at least one transistor, and may be configured to drive the organic light-emitting diode OLED. An insulating layer IL may be located between the substrate 100 and the organic light-emitting diode OLED.

The display area DA of the substrate 100 may include an emission area EA, and a non-emission area NEA surrounding the emission area EA. The emission area EA may be where the emission layer EL of the organic light-emitting diode OLED is arranged to emit light. The emission area EA may be defined by an opening OP of a pixel-defining layer PDL, as illustrated in FIG. 3.

The pixel electrodes PE may be arranged on the substrate 100, and the pixel-defining layer PDL may be arranged between the pixel electrodes PE. The opening OP corresponding to a portion of the pixel electrode PE may be defined in the pixel-defining layer PDL. The emission layer EL may be arranged in the opening OP of the pixel-defining layer PDL, and the opposite electrode CE may be arranged above the emission layer EL. The opposite electrode CE may be located on an upper surface of the pixel-defining layer PDL.

According to one or more embodiments, the organic light-emitting diode OLED may include a tandem light-emitting diode. The tandem light-emitting diode may include two or more emitting units between the pixel electrode PE and the opposite electrode CE, and may include a charge generation layer (CGL) located between the two emitting units. The organic light-emitting diode OLED may have improved color purity and emission efficiency by having a stack structure of the plurality of emitting units.

A separator SPR may be defined in the pixel-defining layer PDL between the pixel electrodes PE. In a plan view, the separator SRP may have a shape at least partially surrounding the pixel electrodes PE. In the plan view, the separator SRP may not completely surround the pixel electrodes PE, and may have an open portion. Adjacent separators SPR may be apart from each other.

The separator SPR may be a concave portion dented by a corresponding depth, which is formed by partially or completely removing the pixel-defining layer PDL. According to one or more embodiments, as illustrated in FIG. 3, after the opposite electrode CE is formed, a portion of the pixel-defining layer PDL may be etched and removed to form the separator SPR. Here, a portion of the opposite electrode CE located above the pixel-defining layer PDL may also be removed, and thus, the opposite electrode CE may include a hole corresponding to the separator SPR. A cross-section of the separator SPR may be U-shaped, triangular-shaped, quadrangular-shaped, ladder-shaped, or polygonal-shaped. In FIG. 3, the separator SPR may have a tapered shape having a width increasing toward the top direction (a z direction). However, the disclosure is not limited thereto. The separator SPR may have an inversely tapered shape having a width decreasing toward the top direction (the z direction). Alternatively, the separator SPR may be provided as a hole passing through the pixel-defining layer PDL, or as a groove not passing through the pixel-defining layer PDL. The separator SPR may reduce or prevent a leakage current between the adjacent organic light-emitting diodes OLED due to the CGL, etc.

FIG. 2 illustrates an example of one unit pixel area PU. In the display area DA, the unit pixel areas PU may be repeatedly arranged in an x direction and a y direction. The unit pixel area PU may include a first pixel PX1, a second pixel PX2, and a third pixel PX3. According to one or more embodiments, the first pixel PX1 may include a red pixel for emitting red light, the second pixel PX2 may include a green pixel for emitting green light, and the third pixel PX3 may include a blue pixel for emitting blue light.

According to one or more embodiments, the plurality of pixels PX may be arranged to have an S-stripe structure. The emission area EA of the first pixel PX1 and the emission area EA of the second pixel PX2 may be alternately arranged in the y direction. The emission area EA of the third pixel PX3 may be repeatedly arranged in the y direction in a column adjacent to a column in which the first pixel PX1 and the second pixel PX2 are arranged. The length of the emission area EA of the third pixel PX3 in the y direction may be equal to or greater than the sum of the length of the emission area EA of the first pixel PX1 in the y direction and the length of the emission area EA of the second pixel PX2 in the y direction.

The emission area EA of the first pixel PX1, the emission area EA of the second pixel PX2, and the emission area EA of the third pixel PX3 may have different areas from each other. According to one or more embodiments, the emission area EA of the third pixel PX3 may have a greater area than the emission area EA of the first pixel PX1. Also, the emission area EA of the third pixel PX3 may have a greater area than the emission area EA of the second pixel PX2. The emission area EA of the first pixel PX1 may have a greater area than the emission area EA of the second pixel PX2. According to one or more other embodiments, the emission area EA of the third pixel PX3 may have the same area as the emission area EA of the first pixel PX1. The disclosure is not limited thereto. For example, the emission area EA of the first pixel PX1 may be greater than the emission area EA of the second pixel PX2 and the emission area EA of the third pixel PX3. Like this, various embodiments are possible.

The emission area EA may have a polygonal shape, such as a quadrangular shape or an octagonal shape, a circular shape, an oval shape, etc., wherein the polygonal shape may include shapes having round corners (vertexes).

The organic light-emitting diodes OLED realizing the first pixel PX1, the second pixel PX2, and the third pixel PX3, respectively, may be connected to the pixel circuits PC, respectively, and may be separately driven.

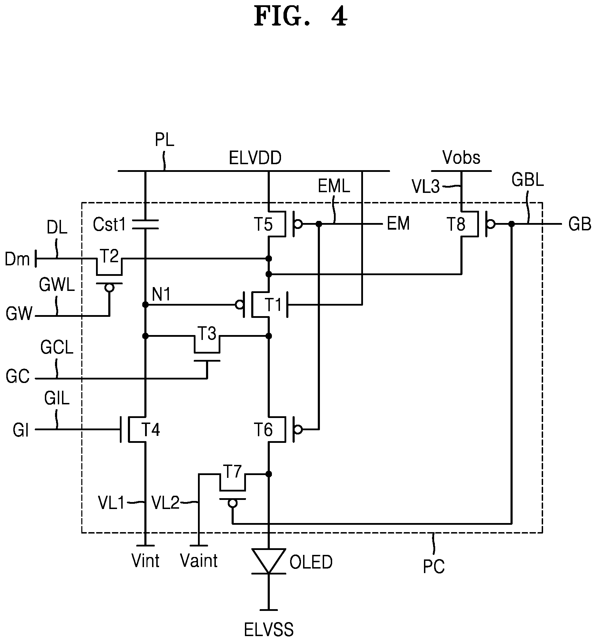

FIG. 4 is a circuit diagram of a pixel circuit according to one or more embodiments.

Referring to FIG. 4, the organic light-emitting diode OLED, which is a light-emitting device, may be connected to the pixel circuit PC, and the organic light-emitting diode OLED may include the pixel electrode (an anode), the opposite electrode (a cathode), and the emission layer between the anode and the cathode.

The pixel circuit PC may be connected to each of a scan line GWL, a first initialization control line GIL, a second initialization control line GBL, a compensation scan line GCL, and an emission control line EML to respectively receive each of a scan signal GW, a first initialization control signal GI, a second initialization control signal GB, a compensation scan signal GC, and an emission control signal EM. Also, the pixel circuit PC may be configured to receive a data signal Dm through a data line DL, and a driving voltage ELVDD through a driving voltage line PL.

The pixel circuit PC may include a plurality of transistors T1, T2, T3, T4, T5, T6, T7, and T8 and a storage capacitance device. The plurality of transistors T1 to T8 may include a driving transistor T1, a switching transistor T2, a compensation transistor T3, a first initialization transistor T4, an operation control transistor T5, an emission control transistor T6, a second initialization transistor T7, and a bias transistor T8. The storage capacitance device may include a capacitor, and in this specification, the storage capacitance device may be represented as a first storage capacitor Cst1.

According to one or more embodiments, one or more of the plurality of transistors T1 to T8 may include p-channel metal-oxide semiconductor field-effect transistor (MOSFET) (PMOS), and one or more others may include n-channel MOSFET (NMOS). For example, from among the plurality of transistors T1 to T8, the driving transistor T1, the switching transistor T2, the operation control transistor T5, the emission control transistor T6, the second initialization transistor T7, and the bias transistor T8 may include the PMOS, and the compensation transistor T3 and the first initialization transistor T4 may include the NMOS. Alternatively, from among the plurality of transistors T1 to T8, the compensation transistor T3 and the first initialization transistor T4 may include the PMOS, and the others may include the NMOS. Alternatively, all of the plurality of transistors T1 to T8 may include the NMOS or the PMOS. Hereinafter, for convenience, it is described that the compensation transistor T3 and the first initialization transistor T4 may include the NMOS including an oxide semiconductor, and the others may include the PMOS.

At least one of the plurality of transistors T1 to T8 may include a transistor having a low-temperature polycrystalline silicon (LTPS) semiconductor layer, and at least one of the plurality of transistors T1 to T8 may include a transistor having an oxide semiconductor layer.

The driving transistor T1, which may directly affect the brightness of the display apparatus, may be provided to include a semiconductor layer including polycrystalline silicon having the high reliability, and thus, the high-resolution display apparatus may be realized. The oxide semiconductor may have higher carrier mobility and low leakage current, and thus, even when there is an increase in driving time, the voltage drop may not be high. That is, a color change of an image due to the voltage drop may not be great during low-frequency driving, and thus, low-frequency driving is possible. As described above, because the oxide semiconductor may have the low leakage current, at least one of the compensation transistor T3 or the first initialization transistor T4 connected to a driving gate electrode of the driving transistor T1 may be provided to include the oxide semiconductor, so as to reduce or prevent the flowing of the leakage current to the driving gate electrode and reduce power consumption. For example, the driving transistor T1, the switching transistor T2, the operation control transistor T5, the emission control transistor T6, the second initialization transistor T7, and the bias transistor T8 may include an LTPS semiconductor layer and the compensation transistor T3 and the first initialization transistor T4 may include an oxide semiconductor layer.

The driving transistor T1 may be connected between the driving voltage line PL configured to receive the driving voltage ELVDD and the organic light-emitting diode OLED. The driving gate electrode of the driving transistor T1 may be connected to an end of the first storage capacitor Cst1. The driving gate electrode of the driving transistor T1 may be connected to a first node N1. A source electrode of the driving transistor T1 may be connected to the driving voltage line PL through the operation control transistor T5. A drain electrode of the driving transistor T1 may be electrically connected to the anode of the organic light-emitting diode OLED through the emission control transistor T6. The driving transistor T1 may be configured to supply a driving current to the organic light-emitting diode OLED by receiving the data signal Dm transmitted by the data line DL, according to a switching operation of the switching transistor T2.

A gate electrode of the switching transistor T2 may be connected to the scan line GWL. A first electrode of the switching transistor T2 may be connected to the data line DL and a second electrode of the switching transistor T2 may be connected to the source electrode of the driving transistor T1. The switching transistor T2 may be turned on according to the scan signal GW received through the scan line GWL, and may be configured to transmit the data signal Dm transmitted through the data line DL to the source electrode of the driving transistor T1, and the data signal Dm may be transmitted to the driving gate electrode of the driving transistor T1 by the compensation transistor T3, which is concurrently or substantially simultaneously turned on.

A gate electrode of the compensation transistor T3 may be connected to the compensation scan line GCL. A first electrode of the compensation transistor T3 may be connected to the drain electrode of the driving transistor T1, and a second electrode of the compensation transistor T3 may be connected to the first node N1. The compensation transistor T3 may be turned on according to the scan signal GW received through the scan line GWL, and may be configured to connect the driving gate electrode of the driving transistor T1 to the drain electrode of the driving transistor T1 to diode connect the driving transistor T1, and to compensate for a threshold voltage Vth of the driving transistor T1.

A gate electrode of the first initialization transistor T4 may be connected to the first initialization control line GIL. A first electrode of the first initialization transistor T4 may be connected to the first initialization voltage line VL1, and a second electrode of the first initialization transistor T4 may be connected to the first node N1. The first initialization transistor T4 may be turned on according to the first initialization control signal GI applied from the first initialization control line GIL, and may be configured to transmit the first initialization voltage Vint to the driving gate electrode of the driving transistor T1 to initialize a potential of the driving gate electrode of the driving transistor T1 (that is, a potential of the first node N1) to a corresponding voltage. The first initialization voltage Vint may be set to be higher than the common voltage ELVSS or the common voltage ELVSS.

A gate electrode of the operation control transistor T5 may be connected to the emission control line EML. A first electrode of the operation control transistor T5 may be connected to the driving voltage line PL and a second electrode of the operation control transistor T5 may be connected to the source electrode of the driving transistor T1.

A gate electrode of the emission control transistor T6 may be connected to the emission control line EML. A first electrode of the emission control transistor T6 may be connected to the drain electrode of the driving transistor T1, and a second electrode of the emission control transistor T6 may be electrically connected to the anode of the organic light-emitting diode OLED. The operation control transistor T5 and the emission control transistor T6 may be concurrently or substantially simultaneously turned on according to the emission control signal EM applied from the emission control line EML. The driving voltage ELVDD applied through the turned-on operation control transistor T5 may be compensated for through the driving transistor T1, and may be transmitted to the organic light-emitting diode OLED.

A gate electrode of the second initialization transistor T7 may be connected to the second initialization control line GBL. A first electrode of the second initialization transistor T7 may be connected to the anode of the organic light-emitting diode OLED, and a second electrode of the second initialization transistor T7 may be connected to the second initialization voltage line VL2. The second initialization transistor T7 may be turned on according to the second initialization control signal GB applied from the second initialization control line GBL, and may be configured to initialize the anode of the organic light-emitting diode OLED. The second initialization control signal GB may be the same signal as the first initialization control signal GI or a different signal from the first initialization control signal GI.

Unlike the disclosure, when the organic light-emitting diode OLED emits light even when a minimum current of the driving transistor T1 for displaying a black image flows as the driving current, the black image may not be appropriately displayed. However, according to the disclosure, the second initialization transistor T7 may distribute, as a bypass current, a portion of a minimum current of the driving transistor T1 into another current path except for a current path at the organic light-emitting diode OLED. Here, the minimum current of the driving transistor T1 may denote a current in the condition in which a gate-source voltage Vgs of the driving transistor T1 is less than a threshold voltage Vth so that the driving transistor T1 is turned off. As described above, a minimum driving current (for example, a current that is equal to or less than 10 picoampere (pA)) in the condition for turning off the driving transistor T1 may be transmitted to the organic light-emitting diode OLED, and an image having black brightness may be displayed. When the minimum driving current for displaying the black image flows, the bypass transmission of the bypass current may have great effects, but when a high driving current for displaying an image, such as a general image or a white image, flows, the bypass current may have few effects. Thus, when the driving current for displaying the black image flows, a precise black brightness image may be realized from the driving current and the contrast ratio may be improved, by using the first initialization transistor T7. Thus, the display apparatus having improved display quality may be provided.

A gate electrode of the bias transistor T8 may be connected to the second initialization control line GBL. A first electrode of the bias transistor T8 may be connected to a bias voltage line VL3 configured to provide a bias voltage Vobs and a second electrode of the bias transistor T8 may be connected to the source electrode of the driving transistor T1.

An end of the first storage capacitor Cst1 may be connected to the driving gate electrode of the driving transistor T1, and the other end of the first storage capacitor Cst1 may be connected to the driving voltage line PL. The first storage capacitor Cst1 may be connected between the driving voltage line PL and the first node N1. The first storage capacitor Cst1 may store a voltage corresponding to the difference between the driving voltage ELVDD and a voltage of the first node N1.

The cathode of the organic light-emitting diode OLED may be connected to the common voltage line configured to apply the common voltage ELVSS. The organic light-emitting diode OLED may receive the driving current from the driving transistor T1, and may emit light to display an image. The driving voltage ELVDD may be a corresponding high-level voltage, and the common voltage ELVSS may be a voltage lower than the driving voltage ELVDD or may be a ground voltage.

Hereinafter, a driving process of the pixel PX will be described. During an initialization period, the first initialization control signal GI of a low level may be supplied to the first initialization transistor T4 through the first initialization control line GIL, and the second initialization control signal GB of a low level may be supplied to the second initialization transistor T7 through the second initialization control line GBL. As a result, each of the first initialization transistor T4 and the second initialization transistor T7 may be turned on. The first initialization voltage Vint applied from the first initialization voltage line VL1 may be transmitted to the driving gate electrode of the driving transistor T1 through the first initialization transistor T4, and may be transmitted to the anode through the second initialization transistor T7. Accordingly, voltages of the driving gate electrode of the driving transistor T1 and the anode may be initialized.

Thereafter, during a data write period, the scan signal GW of a low level may be supplied through the scan line GWL, and the switching transistor T2 and the compensation transistor T3 may be turned on. The switching transistor T2 may be configured to transmit the data signal Dm from the data line DL to the source electrode of the driving transistor T1, and the driving transistor T1 may be diode-connected by the compensation transistor T3. Then, a compensation voltage corresponding to a voltage generated by subtracting the threshold voltage of the driving transistor T1 from the data signal Dm may be applied to the driving gate electrode of the driving transistor T1.

The driving voltage ELVDD and the compensation voltage may be applied to both ends of the storage capacitor Cst1, and a charge corresponding to the difference between the voltages of the both ends may be stored in the storage capacitor Cst1.

Thereafter, during an emission period, the emission control signal EM supplied from the emission control line EML may be changed from a high level to a low level, and the operation control transistor T5 and the emission control transistor T6 may be turned on. Then, a driving current according to the difference between the voltage of the driving gate electrode of the driving transistor T1 and the driving voltage ELVDD may be generated, and the driving current may be supplied to the organic light-emitting diode OLED through the emission control transistor T6 so that the organic light-emitting diode OLED may emit light.

The characteristic of the driving transistor T1 and the characteristic of the light-emitting diode may vary for each of the plurality of pixel circuits PC. For example, during high-frequency driving, color coordinates of the display apparatus 10 may be changed (for example, made more reddish). However, according to the disclosure, the voltage of the source electrode of the driving transistor T1 may be controlled through the bias voltage Vobs by the bias transistor T8. Accordingly, the driving current may be controlled, so that the brightness deviation (the current deviation) and the change of the color coordinates for each pixel may be reduced. Thus, the display apparatus 10 having improved display quality may be provided.

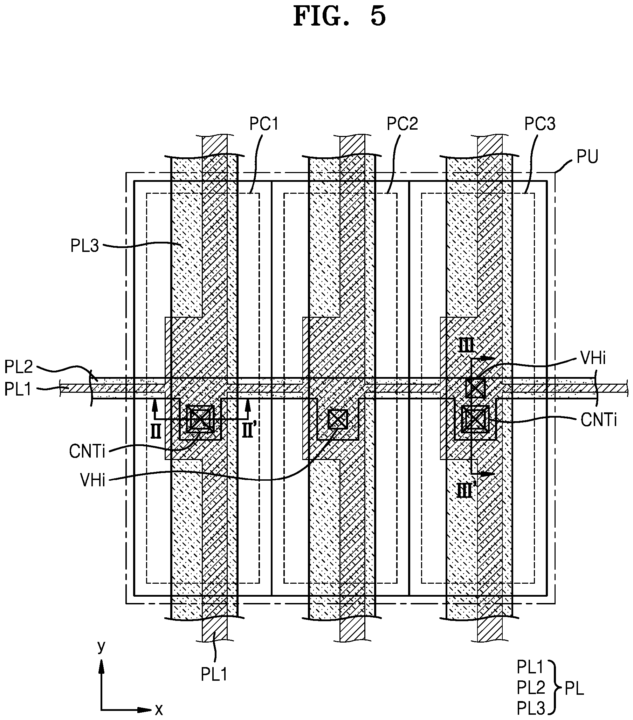

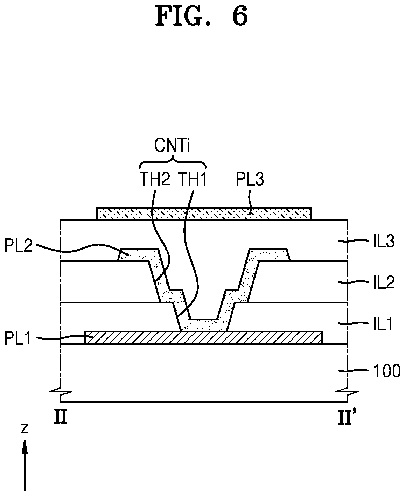

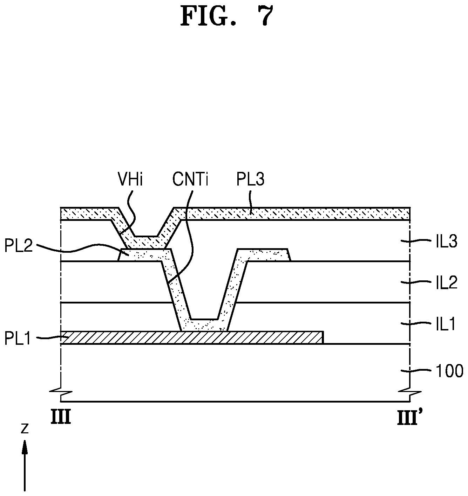

FIG. 5 is a schematic layout view of the driving voltage line PL arranged in the unit pixel area PU. FIG. 6 is a cross-sectional view of some elements corresponding to a region taken along the line II-II' of FIG. 5. FIG. 7 is a cross-sectional view of some elements corresponding to a region taken along the line III-III' of FIG. 5.

In the unit pixel area PU, a first pixel circuit PC1 configured to drive a first pixel, a second pixel circuit PC2 configured to drive a second pixel, and a third pixel circuit PC3 configured to drive a third pixel may be serially arranged in an x direction.

The driving voltage line PL may include the first driving voltage line PL1, the second driving voltage line PL2, and the third driving voltage line PL3 located on different respective layers.

The first driving voltage line PL1 may be provided to have a mesh structure. The first driving voltage line PL1 may include portions extending in the x direction and portions extending in a y direction. The portions of the first driving voltage line PL1 extending in the x direction, and the portions of the first driving voltage line PL1 extending in the y direction, may be alternately and integrally provided. Each of the portions of the first driving voltage line PL1 extending in the y direction may be arranged to correspond to the unit pixel area PU. The portions of the first driving voltage line PL1 extending in the y direction may be arranged to be connected to the first pixel circuit PC1, the second pixel circuit PC2, and the third pixel circuit PC3, respectively.

The second driving voltage line PL2 may extend in the x direction, and may overlap the portions of the first driving voltage line PL1 extending in the x direction. One second driving voltage line PL2 may be arranged to correspond to the unit pixel area PU.

The third driving voltage line PL3 may extend in the y direction, and may overlap the portions of the first driving voltage line PL1 extending in the y direction. The third driving voltage line PL3 may be arranged to be connected to each of the first pixel circuit PC1, the second pixel circuit PC2, and the third pixel circuit PC3.

The first driving voltage line PL1 and the second driving voltage line PL2 may be connected to each other through at least one inner contact hole CNTi for each unit pixel area PU. In FIG. 5, the first driving voltage line PL1 and the second driving voltage line PL2 may be connected to each other through the inner contact hole CNTi in an area of the first pixel circuit PC1 and through the inner contact hole CNTi in an area of the third pixel circuit PC3 in the unit pixel area PU. The disclosure is not limited thereto. The inner contact hole CNTi may be formed in the area of only one of the first to third pixel circuits PC1 to PC3, or may be formed in the areas of all of the first to third pixel circuits PC1 to PC3. Like this, various modifications are possible.

When the inner contact hole CNTi connecting the first driving voltage line PL1 to the second driving voltage line PL2 is not provided in the display area DA, the driving voltage may become non-uniformly applied to the display area DA as the size of the display area DA increases, and thus, the display quality may be affected.

According to embodiments, at least one inner contact hole CNTi may be arranged per unit pixel area PU, and thus, the driving voltage may be uniformly applied in the display area DA.

The second driving voltage line PL2 and the third driving voltage line PL3 may be connected to each other through an inner via hole VHi. According to some embodiments, the second driving voltage line PL2 and the third driving voltage line PL3 may be connected to each other through the inner via hole VHi for each unit pixel area PU. In FIG. 5, the second driving voltage line PL2 and the third driving voltage line PL3 may be connected to each other through the inner via hole VHi in an area of the second pixel circuit PC2 and through the inner via hole VHi in an area of the third pixel circuit PC3 in the unit pixel area PU. The disclosure is not limited thereto. The inner via hole VHi may be formed in the area of only one of the first to third pixel circuits PC1 to PC3 or in the areas of all of the first to third pixel circuits PC1 to PC3. Like this, various modifications are possible.

When the inner via hole VHi connecting the second driving voltage line PL2 to the third driving voltage line PL3 is not provided in the display area DA, the driving voltage may become non-uniformly applied to the display area DA as the size of the display area DA increases, and thus, the display quality may be affected.

According to embodiments, at least one inner via hole VHi may be arranged per unit pixel area PU, and thus, the driving voltage may be uniformly applied in the display area DA.

Also, according to embodiments, in order to realize the high integration of the display apparatus, a method and a location for forming the inner contact hole CNTi, and relative locations of the inner via hole VHi and the inner contact hole CNTi, may be taken into account for designing the display apparatus.

Referring to FIG. 6, the first driving voltage line PL1, the second driving voltage line PL2, and the third driving voltage line PL3 may be located on different layers from each other. The first driving voltage line PL1 may be located on the substrate 100, and a first insulating layer IL1 and a second insulating layer IL2 may be stacked above the first driving voltage line PL1. The second driving voltage line PL2 may be located on the second insulating layer IL2. A third insulating layer IL3 may be located above the second driving voltage line PL2. The third driving voltage line PL3 may be located above the third insulating layer IL3.

Each of the first insulating layer IL1 and the second insulating layer IL2 may include a single inorganic insulating layer or a plurality of inorganic insulating layers. The third insulating layer IL3 may include a single organic insulating layer, or a plurality of organic insulating layers.

The first driving voltage line PL1 and the second driving voltage line PL2 may be connected to each other through the inner contact hole CNTi. The inner contact hole CNTi may include a first through hole TH1 of the first insulating layer IL and a second through hole TH2 of the second insulating layer IL2 overlapping each other. The inner contact hole CNTi may expose an upper surface of the first driving voltage line PL1, and the second driving voltage line PL2 may be in direct contact with the first driving voltage line PL1 through the inner contact hole CNTi.

To form the inner contact hole CNTi, the first through hole TH1 may be formed in the first insulating layer IL, and then, the second through hole TH2 may be sequentially formed in the second insulating layer IL2. Thus, a step-difference structure having a stair shape may be formed at a side surface of the inner contact hole CNTi. That is, a width of the first through hole TH1 may be less than a width of the second through hole TH2.

The disclosure is not limited thereto. The width of the first through hole TH1 may be greater than or equal to the width of the second through hole TH2. That is, various modifications are possible. According to some embodiments, the step-difference structure having the stair shape may not be formed at the side surface of the inner contact hole CNTi.

When the inner contact hole CNTi is formed, the first through hole TH1 and the second through hole TH2 may be formed to overlap each other, and thus, the area of the inner contact hole CNTi may be effectively reduced. Thus, high integration may become possible.

Referring to FIG. 7, the first driving voltage line PL1 and the second driving voltage line PL2 may be connected to each other through the inner contact hole CNTi, and the third driving voltage line PL3 may be connected to the second driving voltage line PL2 through the inner via hole VHi. The inner contact hole CNTi may include a through hole of the first insulating layer IL1 and a through hole of the second insulating layer IL2. The through holes of the first and second insulating layers IL1 and IL2 may overlap each other. As illustrated in FIG. 7, a step-difference structure may not be formed at a side surface of the inner contact hole CNTi.

The third driving voltage line PL3 may be in direct contact with the second driving voltage line PL2 through the inner via hole VHi defined in the third insulating layer IL3. The inner via hole VHi may expose an upper surface of the second driving voltage line PL2, and the third driving voltage line PL3 may be connected to the second driving voltage line PL2 through the inner via hole VHi.

The inner via hole VHi may not overlap the inner contact hole CNTi, or may be offset from the inner contact hole CNTi in plan view. The inner via hole VHi may be formed by applying and developing an organic material to form the third insulating layer IL3. To planarize an upper surface of the third insulating layer IL3, the inner via hole VHi may be arranged not to overlap the inner contact hole CNTi. By planarizing the upper surface of the third insulating layer IL3, defects which may occur when the third driving voltage line PL3, etc. located above the third insulating layer IL3 is formed may be reduced or minimized.

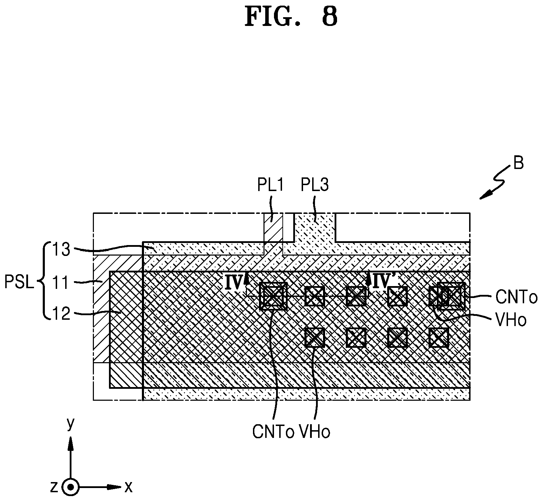

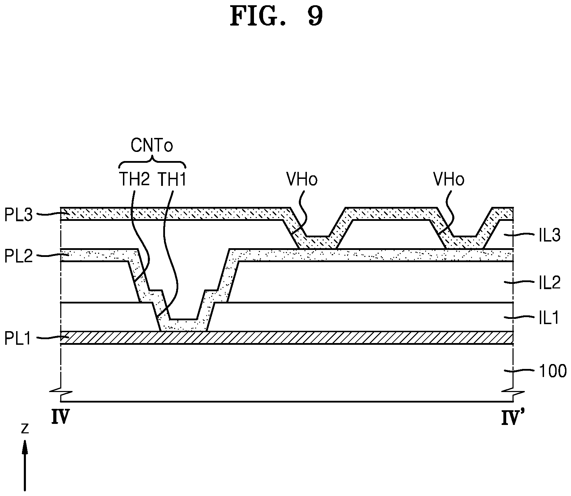

FIG. 8 is a schematic layout view of the power voltage supply line PSL arranged in the peripheral area PA. FIG. 8 may correspond to region B of FIG. 1. FIG. 9 is a cross-sectional view of some elements corresponding to a region taken along the line IV-IV' of FIG. 8.

Referring to FIGS. 8 and 9, the first power voltage supply line 11, the second power voltage supply line 12, and the third power voltage supply line 13 located on different layers from each other may be provided to overlap each other in the peripheral area PA.

The first power voltage supply line 11 may extend in an x direction. The first driving voltage line PL1 may diverge, in a y direction, from one side of the first power voltage supply line 11, and may extend to the display area. The first power voltage supply line 11 and the first driving voltage line PL1 may be integrally formed.

The second power voltage supply line 12 may at least partially overlap the first power voltage supply line 11, and may extend in the x direction. The second power voltage supply line 12 may be connected to the first power voltage supply line 11 through an outer contact hole CNTo.

The third driving voltage line PL3 may diverge, in the y direction, from one side of the third power voltage supply line 13, and may extend to the display area. The third power voltage supply line 13 and the third driving voltage line PL3 may be integrally formed. The third power voltage supply line 13 may at least partially overlap the second power voltage supply line 12, and may extend in the x direction. The third power voltage supply line 13 may be connected to the second power voltage supply line 12 through an outer via hole VHo.

The first power voltage supply line 11 may be located on the substrate 100, and the first insulating layer IL1 and the second insulating layer IL2 may be sequentially located on the first power voltage supply line 11. The second power voltage supply line 12 may be located on the second insulating layer IL2. The third insulating layer IL3 may be located above the second power voltage supply line 12. The third power voltage supply line 13 may be located above the third insulating layer IL3. Each of the first insulating layer IL1 and the second insulating layer IL2 may include a single inorganic insulating layer or a plurality of inorganic insulating layers. The third insulating layer IL3 may include a single organic insulating layer or a plurality of organic insulating layers.

The outer contact hole CNTo may connect the first power voltage supply line 11 to the second power voltage supply line 12 in the peripheral area, and may include the first through hole TH1 of the first insulating layer IL1, and the second through hole TH2 of the second insulating layer IL2, the first and second through holes TH1 and TH2 of the first and second insulating layers IL1 and IL2 overlapping each other. A step-difference structure having a stair shape may be provided at a side surface of the outer contact hole CNTo. A width of the first through hole TH1 may be different from a width of the second through hole TH2. However, the widths of the first through hole TH1 and the second through hole TH2 are not limited thereto. The step-difference structure having the stair shape may not be provided at the side surface of the outer contact hole CNTo. Unlike FIGS. 8 and 9, the outer contact hole CNTo may be provided in a plural number.

The outer via hole VHo may connect the second power voltage supply line 12 to the third power voltage supply line 13 in the peripheral area, and may be provided in a plural number. The outer via hole VHo may be arranged not to overlap the outer contact hole CNTo. However, the outer via hole VHo is not limited thereto. At least one of the outer via holes VHo in the peripheral area may overlap the outer contact hole CNTo, in one or more embodiments. The process sensitivity is not high in the peripheral area, and thus, the outer contact hole CNTo and the outer via hole VHo may be arranged to overlap each other.

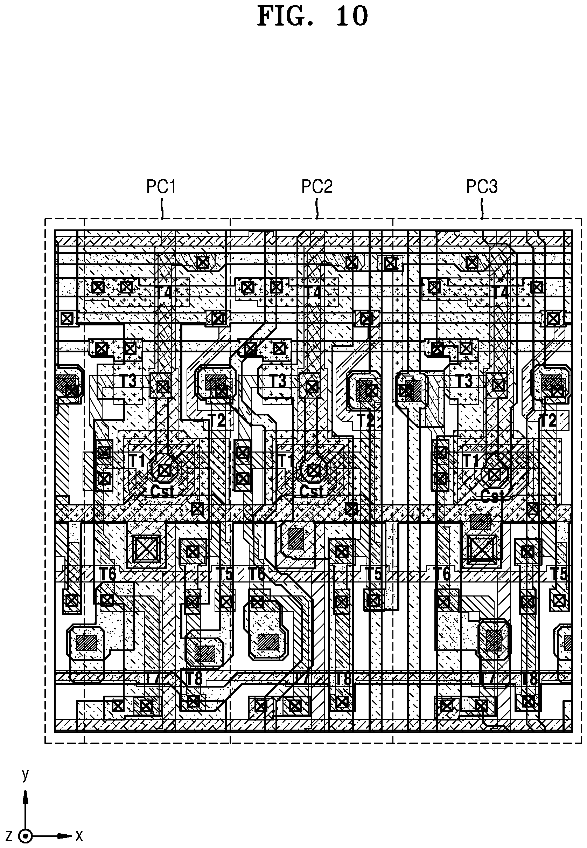

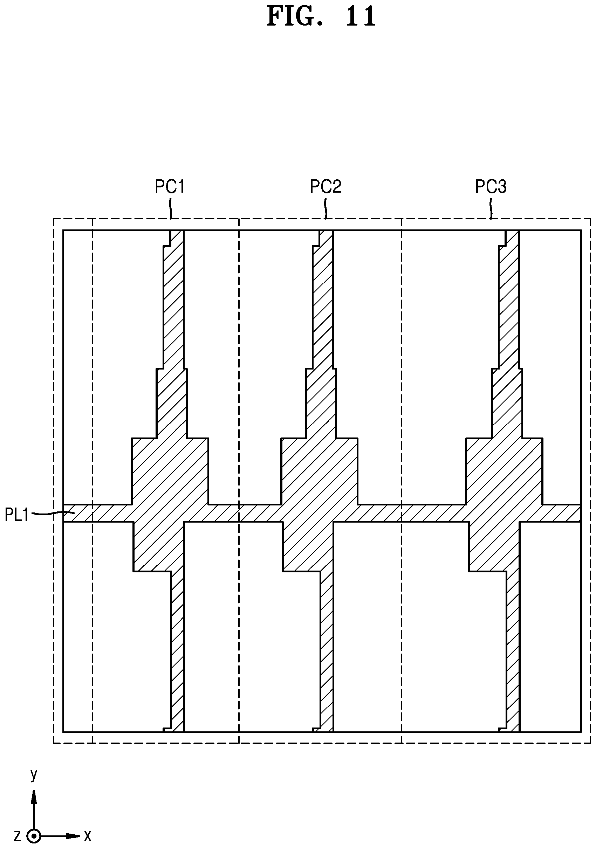

FIG. 10 is a schematic layout view of positions of transistors and a storage capacitor of a pixel circuit, according to one or more embodiments. FIGS. 11 to 20 are schematic layout views of elements of the pixel circuit illustrated in FIG. 10, which are located on each layer.

As illustrated in FIGS. 11 to 20, a display apparatus may include a first pixel circuit PC1, a second pixel circuit PC2, and a third pixel circuit PC3. The first pixel circuit PC1 may be configured to drive the first pixel PX1 (FIG. 2), the second pixel circuit PC2 may be configured to drive the second pixel PX2 (FIG. 2), and the third pixel circuit PC3 may be configured to drive the third pixel PX3 (FIG. 2). Hereinafter, for convenience of explanation, some conductive patterns may be described based on the first pixel circuit PC1. However, these elements may also be arranged in the second pixel circuit PC2 and the third pixel circuit PC3. The structure as illustrated in FIGS. 11 to 20 may be repeatedly arranged in an x direction and/or a y direction.

FIG. 11 illustrates the first driving voltage line PL1.

Referring to FIGS. 10 and 11, a portion of the first driving voltage line PL1 may have a shape to correspond to the driving transistor T1, and may function as a lower protection metal for protecting a portion of the first semiconductor layer 1100 overlapping the first driving voltage line PL1. The first driving voltage line PL1 may include a portion extending in a first direction, and a portion extending in a second direction, in each of the first to third pixels P1 to P3. Thus, the first driving voltage line PL1 may be provided to have a mesh structure. The first driving voltage line PL1 may be integrally provided throughout the first to third pixel circuits PC1 to PC3 or the display area.

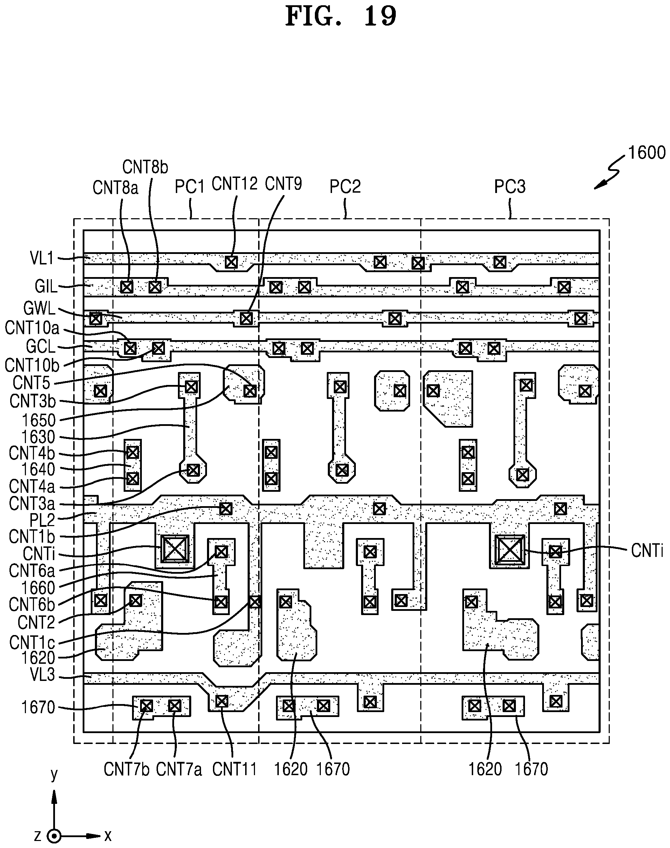

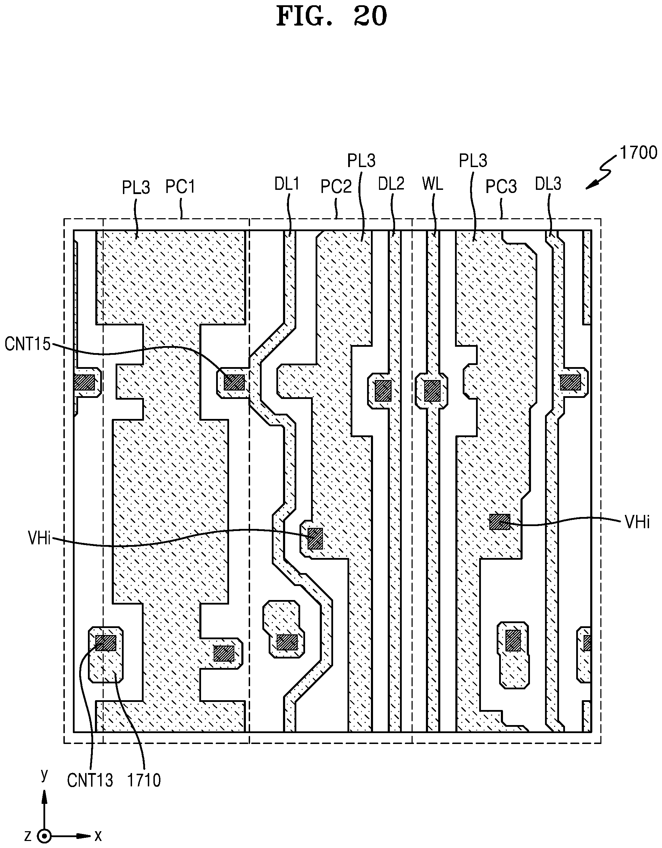

The first driving voltage line PL1 may be electrically connected to the second driving voltage line PL2 (FIG. 19) and the third driving voltage line PL3 (FIG. 20), and thus, an electrical signal the same as an electrical signal applied to the second driving voltage line PL2 and the third driving voltage line PL3 may be applied to the first driving voltage line PL1.

The first driving voltage line PL1 may include metal, an alloy, conductive metal oxide, or a transparent conductive material. For example, the first driving voltage line PL1 may include Ag, an alloy containing Ag, Mo, an alloy containing Mo, Al, an alloy containing Al, AIN, W, WN, Cu, Ni, Cr, CrN, Ti, Ta, Pt, Sc, ITO, IZO, or the like.

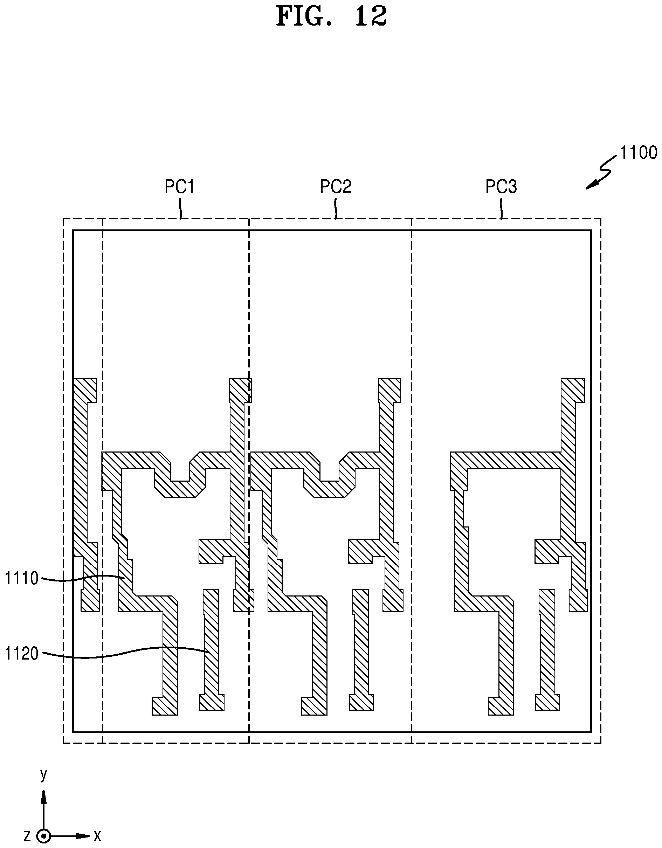

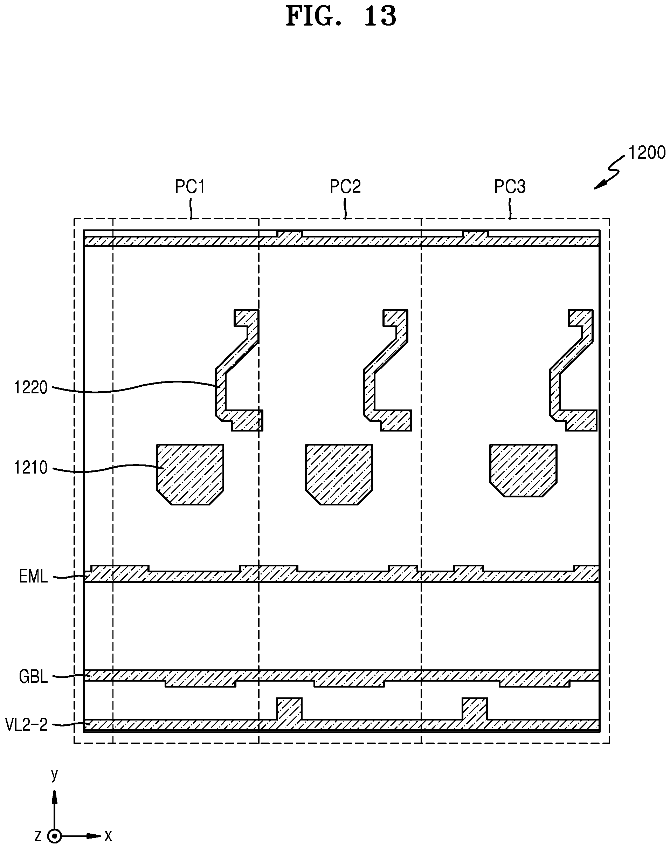

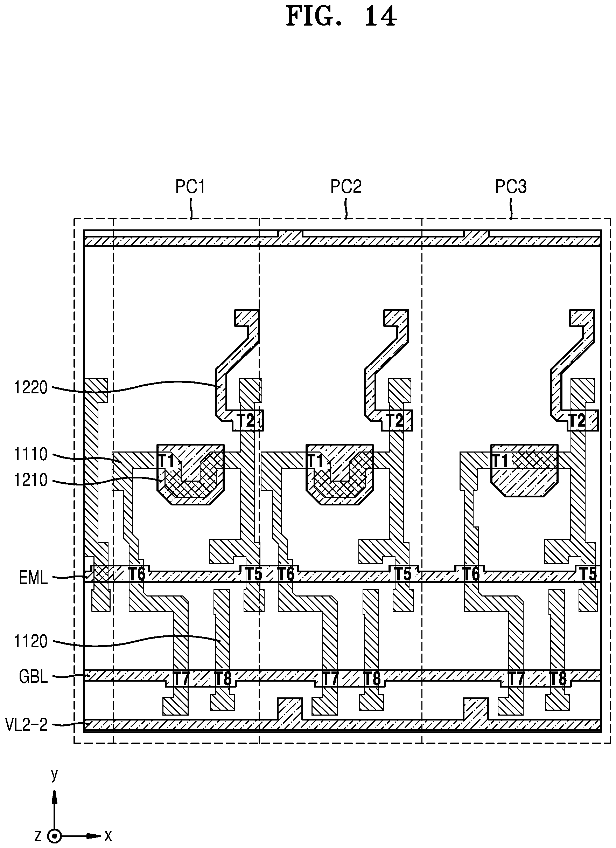

FIG. 12 illustrates the first semiconductor layer 1100 on the first driving voltage line PL1, and FIG. 13 illustrates a first conductive layer 1200 on the first semiconductor layer 1100. FIG. 14 illustrates both the first semiconductor layer 1100 and the first conductive layer 1200, thereby showing the arrangement of the driving transistor T1, the switching transistor T2, the operation control transistor T5, the emission control transistor T6, the second initialization transistor T7, and the bias transistor T8.

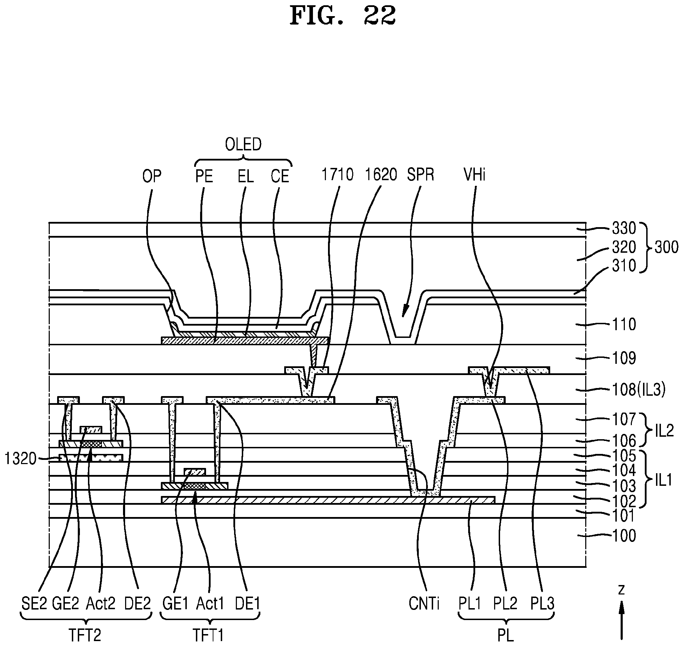

A first interlayer insulating layer 102 (see FIG. 22) to be described below may be located between the first driving voltage line PL1 and the first semiconductor layer 1100. A first gate-insulating layer 103 (see FIG. 22) may be located between the first semiconductor layer 1100 and the first conductive layer 1200.

Referring to FIGS. 10 and 12 to 14, the first semiconductor layer 1100 may include a first semiconductor pattern 1110 and a second semiconductor pattern 1120. That is, the first semiconductor pattern 1110 and the second semiconductor pattern 1120 may be located on the same layer. Each of the first semiconductor pattern 1110 and the second semiconductor pattern 1120 may be arranged for each pixel circuit. For example, each of the first semiconductor pattern 1110 and the second semiconductor pattern 1120 may be arranged for each of the first pixel circuit PC1, the second pixel circuit PC2, and the third pixel circuit PC3.

The driving transistor T1, the switching transistor T2, the operation control transistor T5, the emission control transistor T6, the second initialization transistor T7, and the bias transistor T8 may be positioned along the first semiconductor layer 1100. The driving transistor T1, the switching transistor T2, the operation control transistor T5, the emission control transistor T6, and the second initialization transistor T7 may be positioned in the first semiconductor pattern 1110. The bias transistor T8 may be positioned in the second semiconductor pattern 1120.

The first semiconductor pattern 1110 may include a silicon semiconductor material. For example, the first semiconductor layer 1100 may include amorphous silicon or poly silicon. For example, the first semiconductor layer 1100 may include LTPS. The first semiconductor layer 1100 may include a channel area overlapping a gate electrode, and a source area and a drain area arranged at respective sides of the channel area. The source area and the drain area may be doped with dopants.

The first conductive layer 1200 may be located on the first semiconductor layer 1100. The first conductive layer 1200 may include a first conductive pattern 1210, a second conductive pattern 1220, an emission control line EML, a second initialization control line GBL, and a second-2 initialization voltage line VL2-2. That is, the first conductive pattern 1210, the second conductive pattern 1220, the emission control line EML, the second initialization control line GBL, and the second-2 initialization voltage line VL2-2 may be located on the same layer. The first conductive layer 1200 may be referred to as a first gate layer. Each of the first conductive pattern 1210 and the second conductive pattern 1220 may have an isolated shape.

Each of the first conductive pattern 1210, the second conductive pattern 1220, the emission control line EML, the second initialization control line GBL, and the second-2 initialization voltage line VL2-2 may overlap the first semiconductor layer 1100, and may function as the gate electrode of the transistor.

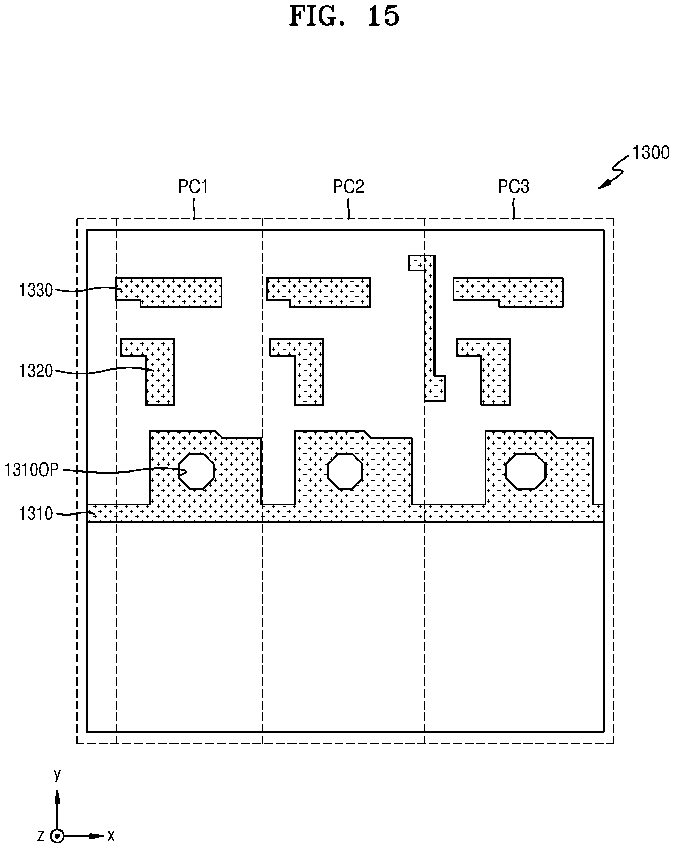

A portion of the first conductive pattern 1210 overlapping the first semiconductor pattern 1110 may be the gate electrode of the driving transistor T1. The first conductive pattern 1210 may overlap an electrode of a second conductive layer 1300 (see FIG. 15) to be described below, and thus, may form the storage capacitor Cst illustrated in FIG. 10. That is, the first conductive pattern 1210 may be an electrode of the storage capacitor Cst. For example, the first conductive pattern 1210 may be a lower electrode of the storage capacitor Cst.

A portion of the second conductive pattern 1220 overlapping the first semiconductor pattern 1110 may be the gate electrode of the switching transistor T2. The second conductive pattern 1220 may be electrically connected to a scan line GWL (FIG. 19) to be described below, and may be configured to receive a scan signal GW. That is, the scan signal GW may be applied to the pixels through the second conductive pattern 1220.

Each of the emission control line EML, the second initialization control line GBL, and the second-2 initialization voltage line VL2-2 may extend in the x direction. The emission control line EML may be configured to transmit an emission control signal EM to each pixel. The second initialization control line GBL may be configured to transmit a second initialization control signal GB to each pixel circuit. The second-2 initialization voltage line VL2-2 may be configured to transmit a second-2 initialization voltage Vaint2 to each of the second pixel circuit PC2 and the third pixel circuit PC3.

A portion of the emission control line EML overlapping the first semiconductor pattern 1110 may be the gate electrode of the operation control transistor T5, and another portion of the emission control line EML overlapping the first semiconductor pattern 1110 may be the gate electrode of the emission control transistor T6.

A portion of the second initialization control line GBL overlapping the first semiconductor pattern 1110 may be the gate electrode of the second initialization transistor T7.

According to one or more embodiments, a second-1 initialization voltage Vaint1 may be transmitted to the second initialization transistor T7 of the first pixel circuit PC1 through a second-1 initialization voltage line VL2-1 of a third conductive layer 1500 to be described below. According to one or more embodiments, the second-2 initialization voltage Vaint2 may be transmitted to the second initialization transistor T7 of the second pixel circuit PC2 through the second-2 initialization voltage line VL2-2 of the first conductive layer 1200. According to one or more embodiments, the second-2 initialization voltage Vaint2 may be transmitted to the second initialization transistor T7 of the third pixel circuit PC3 through the second-2 initialization voltage line VL2-2 of the first conductive layer 1200.

A portion of the second initialization control line GBL overlapping the second semiconductor pattern 1120 may be the gate electrode of the bias transistor T8.

The first conductive layer 1200 may include metal, an alloy, conductive metal oxide, or the like. For example, the first conductive layer 1200 may include Ag, an alloy containing Ag, Mo, an alloy containing Mo, Al, an alloy containing Al, AIN, W, WN, Cu, Ni, Cr, CrN, Ti, Ta, Pt, Sc, ITO, IZO, or the like. The first conductive layer 1200 may include a single layer or multiple layers.

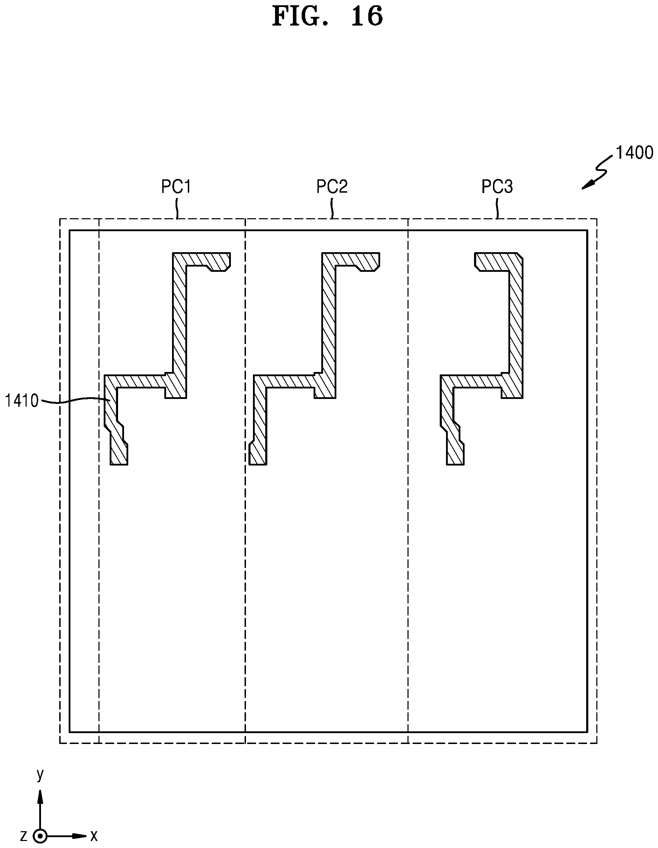

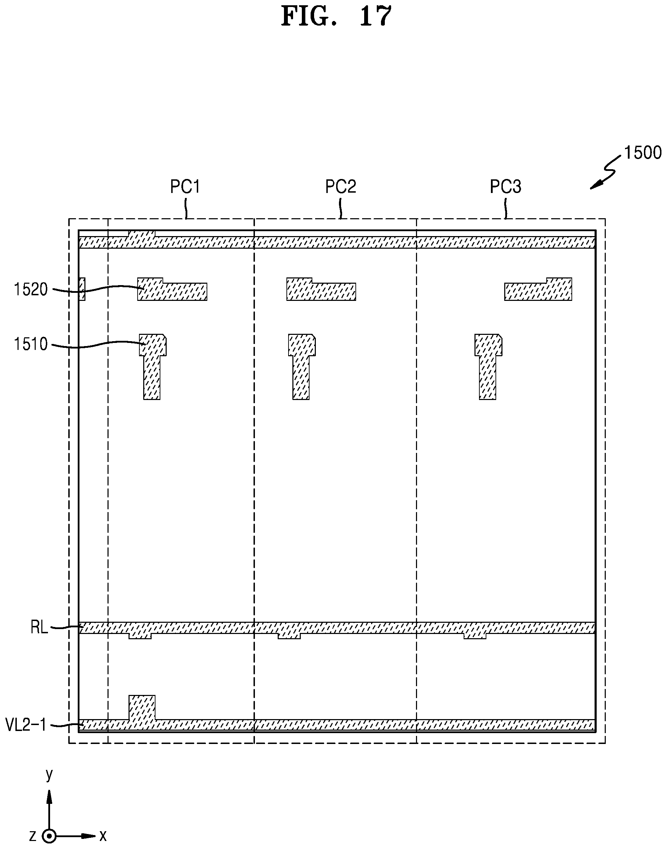

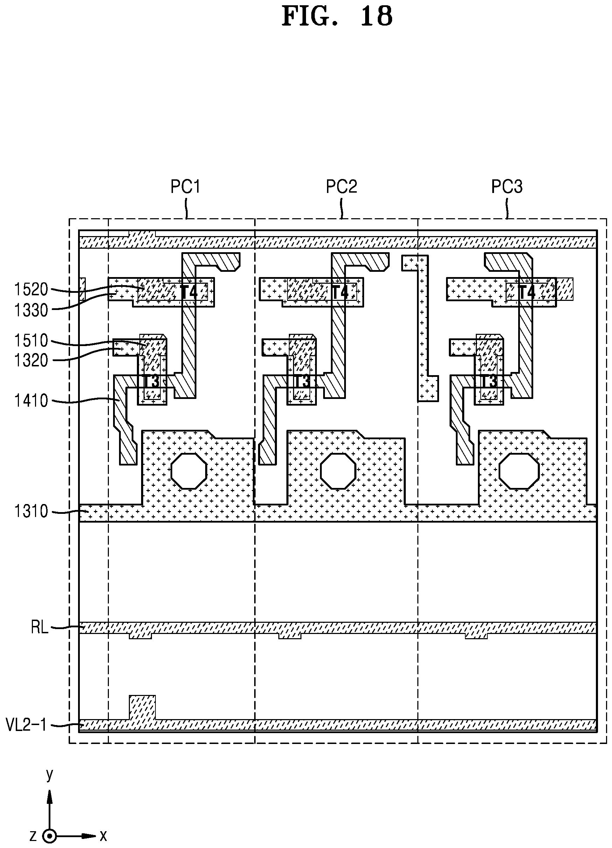

FIG. 15 illustrates the second conductive layer 1300 on the first conductive layer 1200, FIG. 16 illustrates a second semiconductor layer 1400 on the second conductive layer 1300, and FIG. 17 illustrates the third conductive layer 1500 on the second semiconductor layer 1400. FIG. 18 illustrates the second conductive layer 1300, the second semiconductor layer 1400, and the third conductive layer 1500 altogether, thereby showing the arrangement of the compensation transistor T3 and the first initialization transistor T4.

A second gate-insulating layer 104 (see FIG. 22) may be located between the first conductive layer 1200 and the second conductive layer 1300. A second interlayer insulating layer 105 (see FIG. 22) may be located between the second conductive layer 1300 and the second semiconductor layer 1400, and a third gate-insulating layer 106 (see FIG. 22) may be located between the second semiconductor layer 1400 and the third conductive layer 1500.

Referring to FIGS. 10 and 15 to 18, the second conductive layer 1300 may include a third conductive pattern 1310, a fourth conductive pattern 1320, and a fifth conductive pattern 1330. That is, the third conductive pattern 1310, the fourth conductive pattern 1320, and the fifth conductive pattern 1330 may be located on the same layer. The second conductive layer 1300 may be referred to as a second gate layer. The third conductive pattern 1310 may be located to overlap the first conductive pattern 1210. The third conductive pattern 1310 may be located above the first conductive pattern 1210. According to one or more embodiments, the third conductive pattern 1310 may overlap the first conductive pattern 1210 arranged in each of the first to third pixel circuits PC1 to PC3, and may be integrally provided in the first to third pixel circuits PC1 to PC3.

The third conductive pattern 1310 may overlap the first conductive pattern 1210, and may form the storage capacitor Cst (see FIG. 10). That is, the third conductive pattern 1310 may be an electrode of the storage capacitor Cst illustrated in FIG. 10. For example, the third conductive pattern 1310 may be an upper electrode of the storage capacitor Cst.

The third conductive pattern 1310 may define an opening 1310OP having a closed shape. The first conductive pattern 1210 may be electrically connected to a first connection electrode 1630 (see FIG. 20) described below through the opening 1310OP of the third conductive pattern 1310.

Each of the fourth conductive pattern 1320 and the fifth conductive pattern 1330 may have an isolated shape. Each of the fourth conductive pattern 1320 and the fifth conductive pattern 1330 may be arranged in each pixel circuit.

The fourth conductive pattern 1320 may be electrically connected to a compensation scan line GCL (see FIG. 19) described below. A compensation scan signal GC may be transmitted to the fourth conductive pattern 1320 through the compensation scan line GCL. A portion of the fourth conductive pattern 1320 overlapping a third semiconductor pattern 1410 may be a lower gate electrode of the compensation transistor T3.

The fifth conductive pattern 1330 may be electrically connected to a first initialization control line GIL (see FIG. 19) described below. A first initialization control signal GI may be transmitted to the fifth conductive pattern 1330 through the first initialization control line GIL. A portion of the fifth conductive pattern 1330 overlapping the third semiconductor pattern 1410 may be a lower gate electrode of the first initialization transistor T4.

The second conductive layer 1300 may include metal, an alloy, conductive metal oxide, or the like. For example, the second conductive layer 1300 may include Ag, an alloy containing Ag, Mo, an alloy containing Mo, Al, an alloy containing Al, AIN, W, WN, Cu, Ni, Cr, CrN, Ti, Ta, Pt, Sc, ITO, IZO, or the like. The second conductive layer 1300 may include a single layer or multiple layers.

The second semiconductor layer 1400 may be located on the second conductive layer 1300. The second semiconductor layer 1400 may include the third semiconductor pattern 1410. The third semiconductor pattern 1410 may be arranged in each pixel. For example, the third semiconductor pattern 1410 may be arranged for each pixel circuit. The compensation transistor T3 and the first initialization transistor T4 may be positioned in the third semiconductor pattern 1410.

The second semiconductor layer 1400 may include an oxide semiconductor material. For example, the second semiconductor layer 1400 may include oxide of at least one material selected from the group consisting of In, Ga, Sn, Zr, V, Hf, Cd, Ge, Cr, Ti, Al, Cs, Ce, and/or Zn. For example, the second semiconductor layer 1400 may include an InSnZnO (ITZO) semiconductor layer, an InGaZnO (IGZO) semiconductor layer, etc. The oxide semiconductor may have a large band gap (e.g., about 3.1 eV), a high carrier mobility, and a low leakage current, and thus, even when the driving time is increased, the voltage drop may not be high. Thus, during low-frequency driving, there may be a less brightness change according to the voltage drop. The second semiconductor layer 1400 may include a channel area overlapping a gate electrode, and a source area and a drain area arranged at respective sides of the channel area.

The third conductive layer 1500 may be located on the second semiconductor layer 1400. The third conductive layer 1500 may include a sixth conductive pattern 1510, a seventh conductive pattern 1520, a repair line RL, and the second-1 initialization voltage line VL2-1. That is, the sixth conductive pattern 1510, the seventh conductive pattern 1520, the repair line RL, and the second-1 initialization voltage line VL2-1 may be located on the same layer. The third conductive layer 1500 may be referred to as a third gate layer.

Each of the sixth conductive pattern 1510 and the seventh conductive pattern 1520 may have an isolated shape. Each of the sixth conductive pattern 1510 and the seventh conductive pattern 1520 may be arranged in each pixel circuit. Each of the sixth conductive pattern 1510 and the seventh conductive pattern 1520 may overlap the second semiconductor layer 1400, and may function as the gate electrode of the transistor.

A portion of the sixth conductive pattern 1510 overlapping the third semiconductor pattern 1410 may be the gate electrode of the compensation transistor T3. For example, the portion of the sixth conductive pattern 1510 overlapping the third semiconductor pattern 1410 may be an upper gate electrode of the compensation transistor T3. The sixth conductive pattern 1510 may be electrically connected to the compensation scan line GCL (see FIG. 19) described below, and may be configured to receive the compensation scan signal GC.

A portion of the seventh conductive pattern 1520 overlapping the third semiconductor pattern 1410 may be the gate electrode of the first initialization transistor T4. For example, the portion of the seventh conductive pattern 1520 overlapping the third semiconductor pattern 1410 may be an upper gate electrode of the first initialization transistor T4. The seventh conductive pattern 1520 may be electrically connected to the first initialization control line GIL (see FIG. 19) described below, and may be configured to receive the first initialization control signal GI.

The repair line RL may extend in the x direction. In one or more embodiments, the repair line RL may be connected to a dummy pixel circuit, and may be connected to a light-emitting diode of a defective one from among the pixel circuits PC. For example, when the first pixel circuit PC1 is a defective pixel circuit, a laser beam may be irradiated onto where the repair line RL and a first pixel connection electrode 1620 of the first pixel circuit PC1 overlap each other, so that the repair line RL may be connected to the first pixel connection electrode 1620 of the first pixel circuit PC1.

The second-1 initialization voltage line VL2-1 may extend in the first direction (for example, the x direction). According to one or more embodiments, the second-1 initialization voltage line VL2-1 may be configured to transmit the second-1 initialization voltage Vaint1 to the first pixel P1.

The third conductive layer 1500 may include metal, an alloy, conductive metal oxide, or the like. For example, the third conductive layer 1500 may include Ag, an alloy containing Ag, Mo, an alloy containing Mo, Al, an alloy containing Al, AIN, W, WN, Cu, Ni, Cr, CrN, Ti, Ta, Pt, Sc, ITO, IZO, or the like. The third conductive layer 1500 may include a single layer or multiple layers.

FIG. 19 illustrates a fourth conductive layer 1600 on the third conductive layer 1500. FIG. 20 illustrates a fifth conductive layer 1700 on the fourth conductive layer 1600. A first planarization layer 108 (see FIG. 22) may be located between the third conductive layer 1500 and the fourth conductive layer 1600. A second planarization layer 109 (see FIG. 22) may be located between the fourth conductive layer 1600 and the fifth conductive layer 1700.

Referring to FIGS. 10 and 19, the fourth conductive layer 1600 may include the second driving voltage line PL2, the first pixel connection electrode 1620, the first connection electrode 1630, a second connection electrode 1640, a third connection electrode 1650, a fourth connection electrode 1660, a fifth connection electrode 1670, a first initialization voltage line VL1, the first initialization control line GIL, the scan line GWL, the compensation scan line GCL, and a bias voltage line VL3. That is, the elements included in the fourth conductive layer 1600 may be located on the same layer. The fourth conductive layer 1600 may be referred to as a first source/drain layer or a first connection electrode layer.

The second driving voltage line PL2 may extend in the x direction. The second driving voltage line PL2 may be electrically connected to each of the first pixel circuit PC1, the second pixel circuit PC2, and the third pixel circuit PC3, and may be configured to transmit a driving voltage ELVDD.

The second driving voltage line PL2 may be electrically connected to the first driving voltage line PL1 (see FIG. 11) through a first-1 contact hole CNTi. The first-1 contact hole CNTi may be referred to as the inner contact hole CNTi. The second driving voltage line PL2 may be electrically connected to the third conductive pattern 1310 (see FIG. 15) through a first-2 contact hole CNT1b. The second driving voltage line PL2 may be electrically connected to the first semiconductor pattern 1110 (see FIG. 12) through a first-3 contact hole CNT1c. The driving voltage ELVDD may be transmitted to the storage capacitor Cst and to the operation control transistor T5 through the second driving voltage line PL2.

The first pixel connection electrode 1620 may be arranged to be apart from the second driving voltage line PL2. The first pixel connection electrode 1620 may be electrically insulated from the second driving voltage line PL2. The first pixel connection electrode 1620 may be arranged to be apart from the second driving voltage line PL2. The first pixel connection electrode 1620 may be arranged for each pixel circuit.

The first pixel connection electrode 1620 may be electrically connected to the pixel electrode of the organic light-emitting diode. Also, the first pixel connection electrode 1620 may be electrically connected to the first semiconductor pattern 1110 through a second contact hole CNT2.

Each of the first connection electrode 1630, the second connection electrode 1640, the third connection electrode 1650, the fourth connection electrode 1660, and the fifth connection electrode 1670 may have an isolated shape. Each of the first connection electrode 1630, the second connection electrode 1640, the third connection electrode 1650, the fourth connection electrode 1660, and the fifth connection electrode 1670 may be arranged for each pixel circuit.

The first connection electrode 1630 may electrically connect the first conductive pattern 1210 to the third semiconductor pattern 1410. The first connection electrode 1630 may be electrically connected to the first conductive pattern 1210 through a third-1 contact hole CNT3a. The first connection electrode 1630 may be electrically connected to the third semiconductor pattern 1410 through a third-2 contact hole CNT3b. The first connection electrode 1630 may electrically connect the driving transistor T1 to the compensation transistor T3. The first connection electrode 1630 may electrically connect the storage capacitor Cst to the compensation transistor T3.

The second connection electrode 1640 may electrically connect the first semiconductor pattern 1110 to the third semiconductor pattern 1410. The second connection electrode 1640 may be electrically connected to the first semiconductor pattern 1110 through a fourth-1 contact hole CNT4a. The second connection electrode 1640 may be electrically connected to the third semiconductor pattern 1410 through a fourth-2 contact hole CNT4b. The second connection electrode 1640 may electrically connect the driving transistor T1 to the compensation transistor T3. The second connection electrode 1640 may electrically connect the emission control transistor T6 to the compensation transistor T3.

The third connection electrode 1650 may be electrically connected to the first semiconductor pattern 1110 (see FIG. 12) through a fifth contact hole CNT5. For example, the third connection electrode 1650 may be electrically connected to a first data line DL1 described below in the first pixel circuit PC1. That is, the third connection electrode 1650 in the first pixel circuit PC1 may be configured to transmit, to the first semiconductor pattern 1110, a data signal Dm applied through the first data line DL1.

The fourth connection electrode 1660 may electrically connect the first semiconductor pattern 1110 to the second semiconductor pattern 1120. The fourth connection electrode 1660 may be electrically connected to the first semiconductor pattern 1110 through a sixth-1 contact hole CNT6a. The fourth connection electrode 1660 may be electrically connected to the second semiconductor pattern 1120 through a sixth-2 contact hole CNT6b. The fourth connection electrode 1660 may electrically connect the bias transistor T8 to the operation control transistor T5.

In the first pixel circuit PC1, the fifth connection electrode 1670 may electrically connect the first semiconductor pattern 1110 to the second-1 initialization voltage line VL2-1. In the second pixel circuit PC2 and the third pixel circuit PC3, the fifth connection electrode 1670 may electrically connect the first semiconductor pattern 1110 to the second-2 initialization voltage line VL2-2.

In the first pixel circuit PC1, the fifth connection electrode 1670 may be electrically connected to the first semiconductor pattern 1110 through a seventh-1 contact hole CNT7a, and may be electrically connected to the second-1 initialization voltage line VL2-1 through a seventh-2 contact hole CNT7b. The second-1 initialization voltage Vaint1 may be transmitted to the first semiconductor pattern 1110 of the first pixel circuit PC1 through the fourth connection electrode 1660. The fourth connection electrode 1660 may be configured to transmit the second-1 initialization voltage Vaint1 to the second initialization transistor T7 of the first pixel circuit PC1.

In each of the second pixel circuit PC2 and the third pixel circuit PC3, the fifth connection electrode 1670 may be electrically connected to the first semiconductor pattern 1110 through a seventh-1 contact hole CNT7a, and may be electrically connected to the second-2 initialization voltage line VL2-2 through a seventh-2 contact hole CNT7b. In each of the second pixel P2 and the third pixel P3, the second-2 initialization voltage Vaint2 may be transmitted to the first semiconductor pattern 1110 through the fourth connection electrode 1660. The fifth connection electrode 1670 may be configured to transmit the second-2 initialization voltage Vaint2 to the second initialization transistor T7 of the second pixel circuit PC2 and the third pixel circuit PC3.

Each of the first initialization control line GIL, the compensation scan line GCL, the bias voltage line VL3, and the first initialization voltage line VL1 may extend in the x direction.

The first initialization control line GIL may be configured to transmit the first initialization control signal GI. The first initialization control line GIL may electrically connect the fifth conductive pattern 1330 to the seventh conductive pattern 1520. The first initialization control line GIL may be electrically connected to the fifth conductive pattern 1330 through an eighth-1 contact hole CNT8a. The first initialization control line GIL may be electrically connected to the seventh conductive pattern 1520 through an eighth-2 contact hole CNT8b. That is, the first initialization control signal GI may be transmitted to each of the fifth conductive pattern 1330 and the seventh conductive pattern 1520.

The scan line GWL may be configured to transmit the scan signal GW to each pixel. The scan line GWL may be electrically connected to the second conductive pattern 1220 through a ninth contact hole CNT9. That is, the scan signal GW may be transmitted to the second conductive pattern 1220. The scan line GWL may be configured to transmit the scan signal GW to the gate electrode of the switching transistor T2.

The compensation scan line GCL may be configured to transmit the compensation scan signal GC to each pixel. The compensation scan line GCL may electrically connect the fourth conductive pattern 1320 to the sixth conductive pattern 1510. The compensation scan line GCL may be electrically connected to the fourth conductive pattern 1320 through a tenth-1 contact hole CNT10a. The compensation scan line GCL may be electrically connected to the sixth conductive pattern 1510 through a tenth-2 contact hole CNT10b. That is, the compensation scan signal GC may be transmitted to each of the fourth conductive pattern 1320 and the sixth conductive pattern 1510.

A bias voltage Vobs may be applied to the bias voltage line VL3. The bias voltage line VL3 may be electrically connected to the second semiconductor pattern 1120 through an eleventh contact hole CNT11. That is, the bias voltage Vobs may be transmitted to the second semiconductor pattern 1120.

The first initialization voltage Vint may be applied to the first initialization voltage line VL1. The first initialization voltage line VL1 may be electrically connected to the third semiconductor pattern 1410 through a twelfth contact hole CNT12. That is, the first initialization voltage Vint may be applied to the third semiconductor pattern 1410.

The fourth conductive layer 1600 may include metal, an alloy, conductive metal oxide, or the like. For example, the fourth conductive layer 1600 may include Ag, an alloy containing Ag, Mo, an alloy containing Mo, Al, an alloy containing Al, AIN, W, WN, Cu, Ni, Cr, CrN, Ti, Ta, Pt, Sc, ITO, IZO, or the like. The fourth conductive layer 1600 may include a single layer or multiple layers.

Referring to FIGS. 10 and 20, the fifth conductive layer 1700 may be located on the fourth conductive layer 1600. The fifth conductive layer 1700 may include a second pixel connection electrode 1710, the driving voltage line PL (e.g., the third driving voltage line PL3), the first data line DL1, a second data line DL2, and a third data line DL3. That is, the second pixel connection electrode 1710, the driving voltage line PL, the first data line DL1, the second data line DL2, and the third data line DL3 may be located on the same layer. The fifth conductive layer 1700 may be referred to as a second source/drain layer or a second connection electrode layer. The second pixel connection electrode 1710 may be arranged for each pixel circuit. At least a portion of the second pixel connection electrode 1710 may overlap the first pixel connection electrode 1620.

The second pixel connection electrode 1710 may be electrically connected to the organic light-emitting diode driven by each pixel circuit. Also, the second pixel connection electrode 1710 may be electrically connected to the first pixel connection electrode 1620 through a thirteenth contact hole CNT13.

The third driving voltage line PL3 may be configured to apply the driving voltage ELVDD to each pixel circuit. The third driving voltage line PL3 may extend in the y direction. The third driving voltage line PL3 may be electrically connected to the second driving voltage line PL2 through an inner via hole VHi.

The first data line DL1, the second data line DL2, and the third data line DL3 may be electrically connected to the first pixel circuit PC1, the second pixel circuit PC2, and the third pixel circuit PC3, respectively. The first to third data lines DL1 to DL3 may be configured to transmit the data signal Dm to the first to third pixel circuits PC1 to PC3, respectively. Each of the first to third data lines DL1 to DL3 may extend in the y direction.

The first data line DL1 may extend in the y direction, and at least a portion of the first data line DL1 may be curved. This arrangement may be configured to reduce or minimize the interference between different elements. Accordingly, the shape of the first data line DL1 may be different from the shape of the second data line DL2 and the third data line DL3. The length of the first data line DL1 may be greater than the length of the second data line DL2 and the third data line DL3.

The first data line DL1 may be electrically connected to the third connection electrode 1650 through a fifteenth contact hole CNT15 in the first pixel circuit PC1. Likewise, the second data line DL2 in the second pixel circuit PC2 may be electrically connected to the third connection electrode 1650 in the second pixel circuit PC2, and the third data line DL3 in the third pixel circuit PC3 may be electrically connected to the third connection electrode 1650 in the third pixel circuit PC3. The third connection electrode 1650 may be electrically connected to the first semiconductor pattern 1110 (see FIG. 12), and thus, the data signal Dm applied to the first data line DL1 may be transmitted to the first semiconductor pattern 1110. The third connection electrode 1650 may be configured to transmit the data signal Dm to the switching transistor T2.

An additional line WL extending in the y direction may further be provided between the second pixel circuit PC2 and the third pixel circuit PC3. The additional line WL may perform a different function for each unit pixel area PU. For example, the additional line WL may function as the first initialization voltage line that is configured to transmit the first initialization voltage Vint. Alternatively, the additional line WL may function as the second initialization voltage line that is configured to transmit the second initialization voltage Vaint. Alternatively, the additional line WL may function as a common voltage line that is configured to transmit a common voltage ELVSS.

The fifth conductive layer 1700 may include metal, an alloy, conductive metal oxide, or the like. For example, the fifth conductive layer 1700 may include Ag, an alloy containing Ag, Mo, an alloy containing Mo, Al, an alloy containing Al, AIN, W, WN, Cu, Ni, Cr, CrN, Ti, Ta, Pt, Sc, ITO, IZO, or the like. The fourth conductive layer 1600 may include a single layer or multiple layers.

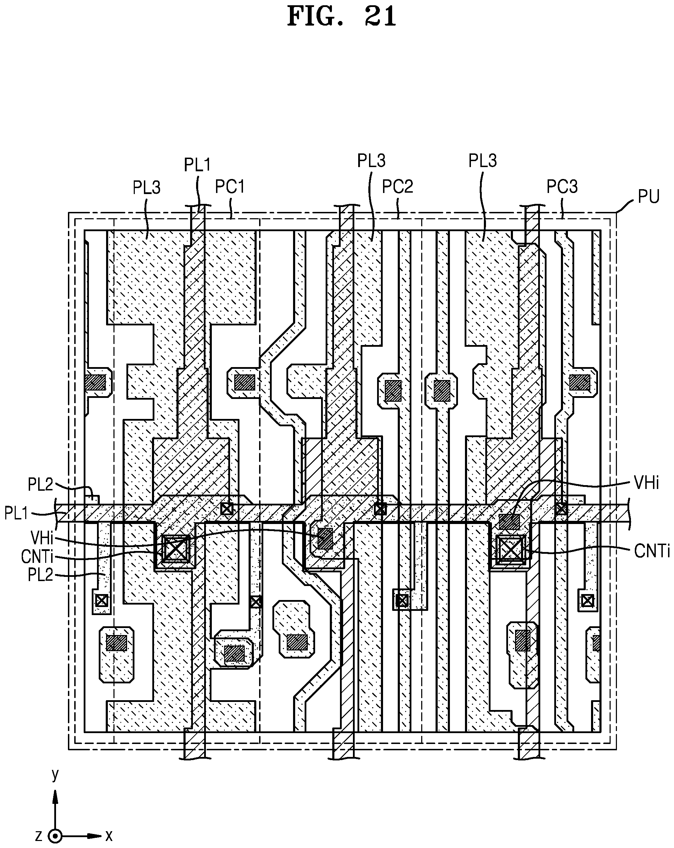

FIG. 21 is a planar layout view of only some of elements of a display apparatus according to one or more embodiments. In detail, FIG. 21 illustrates the first driving voltage line PL1, the second driving voltage line PL2, and the third driving voltage line PL3 overlapping each other.

Referring to FIG. 21, the first driving voltage line PL1 may have a mesh structure extending in an x direction and a y direction. The second driving voltage line PL2 may extend in the x direction, and may overlap a portion of the first driving voltage line PL1 extending in the x direction. The third driving voltage line PL3 may extend in the y direction, and may overlap a portion of the first driving voltage line PL1 extending in the y direction.

The first driving voltage line PL1 and the second driving voltage line PL2 may be connected to each other through the inner contact hole CNTi. One or more inner contact holes CNTi may be arranged for each unit pixel area PU. For example, as illustrated in FIG. 21, two inner contact holes CNTi may be arranged to correspond to the first pixel circuit PC1 and the third pixel circuit PC3 in the unit pixel area PU. However, the inner contact hole CNTi is not limited thereto. The inner contact hole CNTi may be arranged to correspond to only the first pixel circuit PC1 in the unit pixel area PU, or three inner contact holes CNTi may be arranged to correspond to the first to third pixel circuits PC1 to PC3. Like this, various modifications are possible.

The second driving voltage line PL2 and the third driving voltage line PL3 may be connected to each other through the inner via hole VHi. One or more inner via holes VHi may be arranged for each unit pixel area PU. For example, as illustrated in FIG. 21, two inner via holes VHi may be arranged to correspond to the second pixel circuit PC2 and the third pixel circuit PC3 in the unit pixel area PU. However, the inner via hole VHi is not limited thereto. The inner via hole VHi may be arranged to correspond to only the first pixel circuit PC1 in the unit pixel area PU, or three inner via holes VHi may be arranged to correspond to the first to third pixel circuits PC1 to PC3. Like this, various modifications are possible.

When both the inner contact hole CNTi and the inner via hole VHi are arranged in one pixel circuit, the inner contact hole CNTi and the inner via hole VHi may be arranged to be apart from each other in a plan view. This arrangement may be configured to reduce or minimize process defects when forming the inner via hole VHi and the third driving voltage line PL3.

FIG. 22 is a schematic cross-sectional view of a display apparatus according to one or more embodiments.

Referring to FIG. 22, the display apparatus may include the substrate 100, one or more thin-film transistors, namely, first and second thin-film transistors TFT1 and TFT2, located on the substrate 100, the driving voltage line PL, the organic light-emitting diode OLED, and a thin-film encapsulation layer 300.

The substrate 100 may include glass or polymer resins, and may include a plurality of layers. For example, the substrate 100 may include a base layer including polymer resins and an inorganic layer.

A buffer layer 101 may be located on the substrate 100. The buffer layer 101 may reduce or prevent the diffusion of metal atoms or impurities from the substrate 100 onto a semiconductor layer above the substrate 100. The buffer layer 101 may include a single layer or multiple layers including SiO₂, SiNₓ, and/or SiON.

The first driving voltage line PL1 may be located on the buffer layer 101. The first driving voltage line PL1 may be arranged to overlap the first and second thin-film transistors TFT1 and TFT2. FIG. 22 illustrates that the first driving voltage line PL1 may overlap the first thin-film transistor TFT1. However, the first driving voltage line PL1 is not limited thereto. The first driving voltage line PL1 may overlap the second thin-film transistor TFT2. Like this, various modifications are possible.

The first interlayer insulating layer 102 may be located on the first driving voltage line PL1. The first interlayer insulating layer 102 may cover the first driving voltage line PL1 and may be located on the buffer layer 101. The first interlayer insulating layer 102 may include an insulating material. For example, the first interlayer insulating layer 102 may include an inorganic insulating material, such as SiO₂, SiNₓ, and/or SiON.

The first thin-film transistor TFT1 may be located on the first interlayer insulating layer 102. The first thin-film transistor TFT1 may include a first active layer Act1, a first gate electrode GE1, a first source electrode SE1, and a first drain electrode DE1. The first thin-film transistor TFT1 may be electrically connected to the organic light-emitting diode OLED. According to one or more embodiments, the first thin-film transistor TFT1 may include an emission control transistor.

The first active layer Act1 of the first thin-film transistor TFT1 may be located on the first interlayer insulating layer 102. According to one or more embodiments, the first active layer Act1 of the first thin-film transistor TFT1 may correspond to the first semiconductor pattern 1110 of the first semiconductor layer 1100. The first active layer Act1 of the first thin-film transistor TFT1 may include a silicon semiconductor material. For example, the first active layer Act1 may include amorphous silicon or polysilicon. For example, the first active layer Act1 may include LTPS. The first active layer Act1 may include a channel area overlapping the first gate electrode GE1 and a source area and a drain area arranged at respective sides of the channel area.

The first gate-insulating layer 103 may be located on the first active layer Act1. The first gate-insulating layer 103 may cover the first active layer Act1, and may be located on the first interlayer insulating layer 102. The first gate-insulating layer 103 may include an insulating material. For example, the first gate-insulating layer 103 may include an inorganic insulating material, such as SiO₂, SiNₓ, and/or SiON.

The first gate electrode GE1 of the first thin-film transistor TFT1 may be located on the first gate-insulating layer 103. The first gate electrode GE1 may be covered by the second gate-insulating layer 104. The second gate-insulating layer 104 may include an insulating material. For example, the second gate-insulating layer 104 may include an inorganic insulating material, such as SiO₂, SiNₓ, and/or SiON.

The second thin-film transistor TFT2 may be located on the second gate-insulating layer 104. The second thin-film transistor TFT2 may include a second active layer Act2, a second gate electrode GE2, a second source electrode SE2, and a second drain electrode DE2. According to one or more embodiments, the second thin-film transistor TFT2 may include the compensation transistor or the first initialization transistor.

The fourth conductive pattern 1320 may be located on the second gate-insulating layer 104. The fourth conductive pattern 1320 may function as a lower gate electrode of the second thin-film transistor TFT2.

The second interlayer insulating layer 105 may cover the fourth conductive pattern 1320, and may be located on the second gate-insulating layer 104. The second interlayer insulating layer 105 may include an insulating material. For example, the second interlayer insulating layer 105 may include an inorganic insulating material, such as SiO₂, SiNₓ, and/or SiON.

The second active layer Act2 of the second thin-film transistor TFT2 may be located on the second interlayer insulating layer 105. The second active layer Act2 of the second thin-film transistor TFT2 may include an oxide semiconductor material. For example, the second active layer Act2 may include oxide of at least one material selected from the group consisting of In, Ga, Sn, Zr, V, Hf, Cd, Ge, Cr, Ti, Al, Cs, Ce, and/or Zn.

The third gate-insulating layer 106 may cover the second semiconductor layer 1400 (see FIG. 14), and may be located on the second interlayer insulating layer 105. The third gate-insulating layer 106 may include an insulating material. For example, the third gate-insulating layer 106 may include an inorganic insulating material, such as SiO₂, SiNₓ, and/or SiON.

The second gate electrode GE2 of the second thin-film transistor TFT2 may be located on the third gate-insulating layer 106. A third interlayer insulating layer 107 may cover the second gate electrode GE2, and may be located on the third gate-insulating layer 106. The third interlayer insulating layer 107 may include an insulating material. For example, the third interlayer insulating layer 107 may include an inorganic insulating material, such as SiO₂, SiNₓ, and/or SiON.

FIG. 22 illustrates that an upper surface of each of the first interlayer insulating layer 102, the first gate-insulating layer 103, the second gate-insulating layer 104, the second interlayer insulating layer 105, the third gate-insulating layer 106, and the third interlayer insulating layer 107 may be flat. However, the disclosure is not limited thereto. For example, each of the first interlayer insulating layer 102, the first gate-insulating layer 103, the second gate-insulating layer 104, the second interlayer insulating layer 105, the third gate-insulating layer 106, and the third interlayer insulating layer 107 may include an inorganic insulating layer including an inorganic material, and may be arranged to have substantially the same thickness along the profile of the elements.

The first source electrode SE1 and the first drain electrode DE1 of the first thin-film transistor TFT1 may be located on the third interlayer insulating layer 107. According to one or more embodiments, the first drain electrode DE1 of the first thin-film transistor TFT1 may correspond to the first pixel connection electrode 1620. The second source electrode SE2 and the second drain electrode DE2 of the second thin-film transistor TFT2 may be located on the third interlayer insulating layer 107.

The second driving voltage line PL2 may be located on the third interlayer insulating layer 107. The second driving voltage line PL2 may be located on the same layer as the first source/drain electrodes SE1 and DE1 of the first thin-film transistor TFT1, the second source/drain electrode SE2 and DE2 of the second thin-film transistor TFT2, and the first pixel connection electrode 1620.

The second driving voltage line PL2 may be connected to the first driving voltage line PL1 through the inner contact hole CNTi. The inner contact hole CNTi may include through holes of the plurality of insulating layers, the through holes overlapping each other.

The first interlayer insulating layer 102, the first gate-insulating layer 103, the second gate-insulating layer 104, and the second interlayer insulating layer 105 may be commonly referred to as the first insulating layer IL1, and the third gate-insulating layer 106 and the third interlayer insulating layer 107 may be commonly referred to as the second insulating layer IL2. The inner contact hole CNTi may include the through hole of the first insulating layer IL1 and the through hole of the second insulating layer IL2 overlapping each other.

The through hole of the first insulating layer IL1 may be concurrently or substantially simultaneously formed with a through hole for connecting the source electrode SE1 and the drain electrode DE1 of the first thin-film transistor TFT1 to the first active layer Act1. The through hole of the second insulating layer IL2 may be concurrently or substantially simultaneously formed with a through hole for connecting the source electrode SE2 and the drain electrode DE2 of the second thin-film transistor TFT2 to the second active layer Act2. A step-difference having a stair shape may be formed at a side wall of the inner contact hole CNTi. However, the inner contact hole CNTi is not limited thereto. A step-difference may not be formed at the side wall of the inner contact hole CNTi.

The first planarization layer 108 may cover the second driving voltage line PL2, the first source/drain electrodes SE1 and DE1 of the first thin-film transistor TFT1, the second source/drain electrodes SE2 and DE2 of the second thin-film transistor TFT2, and the first pixel connection electrode 1620 and may be located on the third interlayer insulating layer 107.

The first planarization layer 108 may provide a flat upper surface. The first planarization layer 108 may include an organic insulating material. For example, the first planarization layer 108 may include a photoresist, benzocyclobutene (BCB), polyimide, hexamethyldisiloxane (HMDSO), polymethylmethacrylate (PMMA), polystyrene (PS), a polymer derivative having a phenol-based group, an acryl-based polymer, an imide-based polymer, an aryl ether-based polymer, an amide-based polymer, a fluorine-based polymer, a p-xylene-based polymer, a vinyl alcohol-based polymer, or a mixture thereof. The first planarization layer 108 may be referred to as the third insulating layer IL3.

The third driving voltage line PL3 and the second pixel connection electrode 1710 may be located on the first planarization layer 108. The second pixel connection electrode 1710 may be electrically connected to the first pixel connection electrode 1620, and may electrically connect the first thin-film transistor TFT1 to the organic light-emitting diode OLED.

The third driving voltage line PL3 may be connected to the second driving voltage line PL2 through the inner via hole VHi defined in the first planarization layer 108. The third driving voltage line PL3 may be electrically connected to the second driving voltage line PL2, and may be configured to transmit a driving voltage ELVDD to the pixel circuit together with the second driving voltage line PL2 and the first driving voltage line PL1. The inner via hole VHi may be arranged to be apart from the inner contact hole CNTi not to overlap the inner contact hole CNTi. This arrangement may be configured to reduce process defects.

The second planarization layer 109 may cover the third driving voltage line PL3 and the second pixel connection electrode 1710, and may be located on the first planarization layer 108. The second planarization layer 109 may provide a flat upper surface.

The second planarization layer 109 may include an organic insulating material. For example, the second planarization layer 109 may include a photoresist, BCB, polyimide, HMDSO, PMMA, PS, a polymer derivative having a phenol-based group, an acryl-based polymer, an imide-based polymer, an aryl ether-based polymer, an amide-based polymer, a fluorine-based polymer, a p-xylene-based polymer, a vinyl alcohol-based polymer, or a mixture thereof.

The organic light-emitting diode OLED may be located on the second planarization layer 109. The organic light-emitting diode OLED may include the pixel electrode PE, the emission layer EL, and the opposite electrode CE.

A pixel-defining layer 110 may be located on the second planarization layer 109. The pixel-defining layer 110 may increase a distance between an edge of the pixel electrode PE and the opposite electrode CE, which is above the pixel electrode PE, so as to reduce or prevent the likelihood of the occurrence of arcs, etc. at the edge of the pixel electrode PE. The pixel-defining layer 110 may be formed by spin coating, etc. by using at least one organic insulating material selected from the group consisting of polyimide, polyamide, acryl resins, BCB, and/or phenol resins.

The separator SPR may be defined in the pixel-defining layer 110. The separator SPR may be a concave portion dented by a corresponding depth, which is formed by partially or completely removing the pixel-defining layer 110. According to one or more embodiments, after the opposite electrode CE is formed, a portion of the pixel-defining layer 110 may be etched and removed to form the separator SPR. Here, a portion of the opposite electrode CE located above the pixel-defining layer 110 may also be removed, and thus, the opposite electrode CE may include a hole corresponding to the separator SPR. A cross-section of the separator SPR may be U-shaped, triangular-shaped, quadrangular-shaped, ladder-shaped, or polygonal-shaped. In FIG. 22, the separator SPR may have a tapered shape having a width increasing toward the top direction (a z direction). However, the disclosure is not limited thereto. The separator SPR may have an inversely tapered shape having a width decreasing toward the top direction (the z direction). However, the separator SPR may be provided as a hole passing through the pixel-defining layer 110, or as a groove not passing through the pixel-defining layer 110. Alternatively, the separator SPR may be provided as a hole or a groove passing through the pixel-defining layer 110 and through the second planarization layer 109, which is below the pixel-defining layer 110.

At least a portion of the emission layer EL of the organic light-emitting diode OLED may be arranged in an opening OP formed by the pixel-defining layer 110. The emission layer EL may include an organic material including a fluorescent or phosphorescent material for emitting red, green, blue, or white light. The emission layer EL may include a low molecular-weight organic material or a high molecular-weight organic material. Also, a functional layer, such as a hole transport layer (HTL), a hole injection layer (HIL), an electron transport layer (ETL), and an electron injection layer (EIL), may further be selectively located below and above the emission layer EL.

According to one or more embodiments, the organic light-emitting diode OLED may include a tandem light-emitting diode. The tandem light-emitting diode may include two or more emitting units between the pixel electrode PE and the opposite electrode CE, and a CGL located between the two emitting units. The organic light-emitting diode OLED may have improved color purity and emission efficiency by having a stack structure of the plurality of emitting units. The CGL may be disconnected by the separator SPR. Thus, a leakage current due to the CGL may not occur.

The opposite electrode CE may include a transmissive electrode or a reflection electrode. For example, the opposite electrode CE may include a transparent or a transflective electrode, and may include a metal thin layer having a small work function including Li, Ca, LiF, Al, Ag, Mg, and a compound thereof. Also, the opposite electrode CE may further include a transparent conductive oxide (TCO) layer, such as ITO, IZO, ZnO, or In₂O₃, on the metal thin layer. The opposite electrode CE may be integrally formed on the entire surface of the display area, and may be arranged above the emission layer EL and the pixel-defining layer 110.

The thin-film encapsulation layer 300 may be located on the organic light-emitting diode OLED to encapsulate the organic light-emitting diode OLED. The thin-film encapsulation layer 300 may include at least one inorganic layer and at least one organic layer. For example, the thin-film encapsulation layer 300 may include a first inorganic encapsulation layer 310, an organic encapsulation layer 320, and a second inorganic encapsulation layer 330 that are sequentially stacked.

The first inorganic encapsulation layer 310 and the second inorganic encapsulation layer 330 may include an inorganic insulating material, such as SiO₂, SiNₓ, SiON, aluminum oxide (Al₂O₃), titanium oxide (TiO₂), tantalum oxide (Ta₂O₅), or hafnium oxide (HfO₂). The first and second inorganic encapsulation layers 310 and 330 may include a single layer or multiple layers including the inorganic insulating material described above.

The organic encapsulation layer 320 may reduce the inner stress of the first inorganic encapsulation layer 310 and/or the second inorganic encapsulation layer 330. The organic encapsulation layer 320 may include a polymer-based material. The polymer-based material may include polyethylene terephthalate, polyethylene naphthalate, polycarbonate, polyimide, polyethylene sulfonate, polyoxymethylene, polyarylate, HMDSO, acryl-based resins (for example, PMMA, poly acrylic acid, etc.), or an arbitrary combination thereof.

The organic encapsulation layer 320 may be formed by applying a material having flowability and including monomers, and by making (e.g., by using heat or light such as ultraviolet rays) the monomers react to unite to become a polymer. Alternatively, the organic encapsulation layer 320 may be formed by applying a polymer material.

Various members, such as a touch screen layer, a color filter layer, a polarization film layer, a window, etc., may further be located above the thin-film encapsulation layer 300.

The display apparatus according to embodiments may be included in an electronic device. The electronic device according to an embodiment may display a motion image or a static image and may be used as a display screen of not only of portable electronic devices, such as a mobile phone, a smartphone, a tablet personal computer (PC), a mobile communication terminal, an electronic notebook, an electronic book, a portable multimedia player (PMP), a navigation device, and an ultra-mobile PC (UMPC), but also of various products, such as a television (TV), a notebook computer, a monitor, a signboard, the Internet of things (IOT) device, etc. The electronic device according to an embodiment may be used for wearable devices, such as a smart watch, a watch phone, a glasses-type display, and a head-mounted display (HMD). The electronic device according to an embodiment may be used as a center information display (CID) on a gauge of a vehicle or a center fascia or a dashboard of the vehicle; a room mirror display substituting a side-view mirror of a vehicle; or a display disposed on a rear surface of a front seat, as an entertainment device for a backseat of a vehicle.

According to the embodiments described above, a display apparatus may have improved display quality by including driving voltage lines located on different layers, the driving voltage lines being connected to each other through a contact hole in each pixel unit. However, the scope of the disclosure is not limited to the effect as described above.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by one of ordinary skill in the art that various changes in form and details may be made therein without departing from the spirit and scope as defined by the following claims, with functional equivalents thereof to be included therein.

## Claims

1. A display apparatus (10) comprising:
a substrate (100) comprising a display area (DA) and a peripheral area (PA);
unit pixel areas (PU) in the display area (DA), and comprising a first pixel circuit (PC1), a second pixel circuit (PC2), and a third pixel circuit (PC3);
a power voltage supply line (PSL) in the peripheral area (PA);
a first driving voltage line (PL1) electrically connected to the power voltage supply line (PSL), and having a mesh structure in the display area (DA); and
a second driving voltage line (PL2) electrically connected to the power voltage supply line (PSL), at a different layer from the first driving voltage line (PL1), extending in a first direction in the display area (DA), and connected to the first driving voltage line (PL1) through at least one inner contact hole (CNTi) in the unit pixel areas (PU).

2. The display apparatus (10) of claim 1, wherein a step difference having a stair shape is at a side surface defining the at least one inner contact hole (CNTi).

3. The display apparatus (10) of claim 1 or 2, further comprising a first insulating layer (IL1) and a second insulating layer (IL2) that are stacked between the first driving voltage line (PL1) and the second driving voltage line (PL2),
wherein the at least one inner contact hole (CNTi) comprises a first through hole (TH1) of the first insulating layer, and a second through hole (TH2) of the second insulating layer, the first through hole (TH1) and the second through hole (TH2) overlapping each other, and a width of the first through hole (TH1) being different from a width of the second through hole (TH2).

4. The display apparatus (10) of claims 1 to 3, wherein the first driving voltage line (PL1) comprises a portion extending in the first direction and overlapping the second driving voltage line (PL2), and a portion extending in a second direction crossing the first direction.

5. The display apparatus (10) of claims 1 to 4, further comprising a third driving voltage line (PL3) electrically connected to the power voltage supply line (PSL), at a different layer from the first driving voltage line (PL1) and the second driving voltage line (PL2), extending in a second direction crossing the first direction in the display area, and connected to the second driving voltage line (PL2) through at least one inner via hole (VHi) in each of the unit pixel areas (PU) and/or further comprising a third insulating layer (IL3) between the second driving voltage line (PL2) and the third driving voltage line (PL3), and defining the at least one inner via hole, the at least one inner via hole (VHi) not overlapping the at least one inner contact hole (CNTi) or wherein the first driving voltage line (PL1) comprises a portion extending in the first direction, and a portion extending in the second direction, and overlapping the third driving voltage line (PL3).

6. The display apparatus (10) of claims 1 to 5, wherein the power voltage supply line (PSL) is in the peripheral area (PA), and comprises a first power voltage supply line (11) surrounding the display area (DA) in plan view at a same layer as the first driving voltage line, a second power voltage supply line (12) at a same layer as the second driving voltage line (PL2), and a third power voltage supply line (13) at a different layer from the first power voltage supply line (11) and the second power voltage supply line (12) and/or wherein the first power voltage supply line (11) is integral with the first driving voltage line.

7. The display apparatus (10) of claim 6, wherein the second power voltage supply line (12) extends in the first direction in the peripheral area (PA).

8. The display apparatus (10) of claim 6, wherein the first power voltage supply line (11) and the second power voltage supply line (12) are connected through outer contact holes in the peripheral area (PA) and/or wherein a step difference having a stair shape is at a side surface defining one of the outer contact holes.

9. The display apparatus (10) of claim 8, wherein the third power voltage supply line (13) is connected to the second power voltage supply line (12) through outer via holes, at least one of the outer via holes at least partially overlapping the outer contact holes.

10. The display apparatus (10) of claims 1 to 9, wherein the first pixel circuit (PC1) comprises a first thin-film transistor (TFT1) comprising a silicon semiconductor layer, and a second thin-film transistor (TFT2) comprising an oxide semiconductor layer, and
wherein the first driving voltage line (PL1) overlaps at least one of the first thin-film transistor (TFT1) or the second thin-film transistor (TFT2).

11. A display apparatus (10) comprising:
a substrate (100) comprising a display area (DA) and a peripheral area (PA);
a pixel circuit in the display area (DA), and comprising a first thin-film transistor (TFT1) comprising a first semiconductor layer (1100) and
a second thin-film transistor (TFT2) comprising a second semiconductor layer (1400) at a different layer from the first semiconductor layer (1100);
a display element connected to the pixel circuit;
a first driving voltage line (PL1) between the substrate (100) and the first semiconductor layer (1100);
a first insulating layer (IL1) below the second semiconductor layer (1400), and covering the first semiconductor layer (1100);
a second insulating layer (IL2) above the first insulating layer (IL1), and covering the second semiconductor layer (1400);
a second driving voltage line (PL2) above the second insulating layer (IL2), and connected to the first driving voltage line (PL1) through an inner contact hole (CNTi) in the display area (DA);
a third insulating layer (IL3) above the second insulating layer (IL2), and covering the second driving voltage line (PL2); and
a third driving voltage line (PL3) above the third insulating layer and/or. wherein the inner contact hole (CNTi) comprises a first through hole (TH1) of the first insulating layer (IL1) and a second through hole (TH2) of the second insulating layer, the first through hole (TH1) and the second through hole (TH2) overlapping each other.

12. An electronic device comprising a display apparatus (10), wherein the display apparatus (10) comprises:
a substrate (100) comprising a display area (DA) and a peripheral area (PA);
a plurality of unit pixel areas (PU) arranged in the display area (DA) and each comprising a first pixel circuit (PC1), a second pixel circuit (PC2), and a third pixel circuit (PC2);
a power voltage supply line (PSL) arranged in the peripheral area (PA);
a first driving voltage line (PL1) electrically connected to the power voltage supply line (PSL) and arranged in the display area to have a mesh structure; and
a second driving voltage line (PL2) electrically connected to the power voltage supply line (PSL), disposed on a different layer from the first driving voltage line, and extending in a first direction in the display area,
wherein the first driving voltage line (PL1) is connected to the second driving voltage line (PL2) through at least one inner contact hole (CNTi) in each of the plurality of unit pixel areas (PU) and/or wherein a step difference having a stair shape is provided at a side surface of the at least one inner contact hole.

13. The electronic device of claim 12, further comprising a first insulating layer (IL1) and a second insulating layer (IL2) which are stacked between the first driving voltage line (PL1) and the second driving voltage line,
wherein the at least one inner contact hole (CNTi) comprises a first through hole (TH1) of the first insulating layer and a second through hole (TH2) of the second insulating layer, the first through hole (TH1) and the second through hole (TH2) overlapping each other, and a width of the first through hole (TH1) is different from a width of the second through hole.

14. The electronic device of claim 12, further comprising a third driving voltage line (PL3) electrically connected to the power voltage supply line (PSL) and disposed on a different layer from the first driving voltage line (PL1) and the second driving voltage line (PL2),
wherein the third driving voltage line (PL3) extends in a second direction crossing the first direction in the display area (DA), and
the third driving voltage line (PL3) is connected to the second driving voltage line (PL2) through at least one inner via hole (VHi) in each of the plurality of unit pixel areas (PU).

15. The electronic device of claim 12, further comprising a first display element, a second display element, and a third display element which are arranged in the display area (DA) and respectively connected to the first pixel circuit (PC1), the second pixel circuit (PC2), and the third pixel circuit (PC3),
wherein each of the first display element, the second display element, and the third display element comprises organic light-emitting diodes (OLED) having a tandem structure and/or wherein a pixel-defining layer (PDL) defining an emission area (EA) each of the organic light-emitting diodes (OLED) comprises a separator (SPR) arranged between the organic light-emitting diodes (OLED) and having a concave structure.
